(19) Europäisches Patentamt
European Patent Office
Office européen des brevets

(11) EP 1 071 130 A2

(12) **EUROPEAN PATENT APPLICATION**

(43) Date of publication:
**24.01.2001 Bulletin 2001/04**

(51) Int. Cl.$^7$: **H01L 23/522**

(21) Application number: **00115236.2**

(22) Date of filing: **13.07.2000**

(84) Designated Contracting States:
**AT BE CH CY DE DK ES FI FR GB GR IE IT LI LU MC NL PT SE**
Designated Extension States:
**AL LT LV MK RO SI**

(30) Priority: **14.07.1999 JP 20084599**

(71) Applicant:
**MATSUSHITA ELECTRIC INDUSTRIAL CO., LTD.**
**Kadoma-shi, Osaka-fu 571 (JP)**

(72) Inventors:
- **Tamaru, Masaki**
  **Takatsuki-shi, Osaka (JP)**
- **Moriwaki, Toshiyuki**
  **Sakai-shi, Osaka (JP)**
- **Suzuki, Ryoichi**
  **Takatsuki-shi, Osaka (JP)**

(74) Representative:
**Grünecker, Kinkeldey,**
**Stockmair & Schwanhäusser**
**Anwaltssozietät**
**Maximilianstrasse 58**
**80538 München (DE)**

# (54) Semiconductor device interconnection structure comprising additional capacitors

(57) A supplemental capacitor is formed using the large capacitance between the wirings (M11 and M12) and that between the through-holes (B11 and B12) because of downsizing of the process technique. The inter-wiring capacitor and inter-through-hole capacitor can be arranged at any optional position within the semiconductor device. The supplemental capacitor can be easily formed in the vicinity of the area where switching noise is generated, thereby effectively realizing the countermeasure for power source noise. In the process technique with advanced downsizing, a capacitor having large capacitance can be formed with a smaller area. In addition, the capacitor can be formed in the same process as the other device such as a transistor without adding any special step.

FIG. 1 (a)

FIG. 1 (b)

FIG. 1 (c)

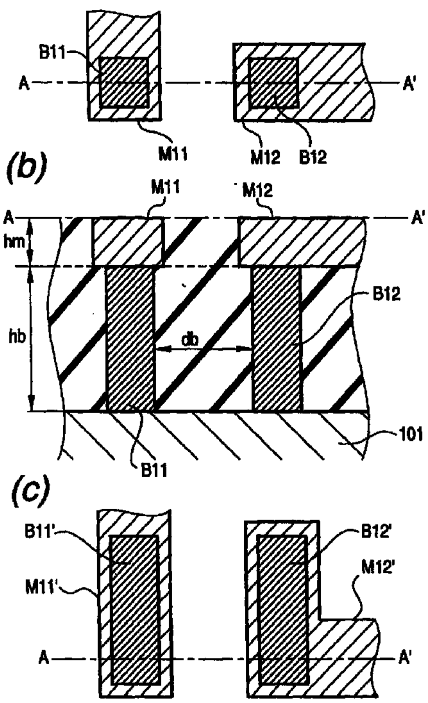


EP 1 071 130 A2

## Description

Background of the Invention

1. Field of the Invention

The present invention relates to a semiconductor device and a method of manufacturing it, and more particularly to a semiconductor device and a method of manufacturing it which can form a capacitor at a desired position to make a countermeasure for power source noise, and can form a capacitor having large capacitance within a smaller area in a process technique for advanced downsizing.

2. Description of the related Art

Generally, in a semiconductor device in which an analog circuit and a digital circuit are mixedly located, or which operates at a low voltage, the power source noise which is generated by the digital circuit in the semiconductor device is problematic.

In order to suppress such power source noise, a technique has been proposed which forms a trunk (power source) wiring on the peripheral portion of a semiconductor device in two layers to increase the capacitance given to the power source wiring. The power source noise is switching noise which occurs owing to a change in a power source current resulting from a change in the signal mainly supplied to the digital circuit. Therefore, this technique charges a supplemental capacitor when the signal does not change so that the supplemental capacitor serves as a power source voltage at the time of switching when the signal changes, thereby suppressing an abrupt change in the power source voltage to attenuate a noise level.

However, the countermeasure for suppressing power source noise in the conventional semiconductor device is problematic since it can automatically deal with only the power source wiring on the trunk (outer periphery) because of the constraints of wiring by an arranging/wiring tool in a system for assisting at the design of a semiconductor device.

Particularly, where more strict suppressing of the noise is required, a countermeasure can be proposed which separately forms a capacitor having a large capacitance using conductive films of two wiring layers on the semiconductor device and provides it to a power source wiring. However, the parallel-plate type capacitor using wiring layers, which requires a separate area therefor, is an obstacle against high integration. This is remarkable in the case of the process technique with advanced downsizing.

Summary of the Invention

The present invention has been accomplished in order to solve the problems related to the conventional technique. An object of the invention is to provide a semiconductor device and a method of manufacturing it which can form a capacitor at a desired position to make a countermeasure for power source noise, and can form a capacitance having a large capacitance within a smaller area in a process technique for advanced downsizing.

Another object of the invention is to provide a semiconductor device and a method of manufacturing it which can form a capacitor having a large capacitance within a smaller area in a process technique with advanced downsizing and can form the capacitor without adding any special step in the same process as other devices such as a transistor.

In order to solve the above problems, the present invention defines a semiconductor device comprising:

a first conductive layer formed of a surface of a semiconductor substrate;
a second conductive layer which is formed close to the first conductive layer, wherein
a distance between the first conductive layer and the second conductive layer is determined in accordance with a permittivity of the insulating layer.

Preferably the second conductive layer is made of a conductive film being filled in a through hole being located close to said first, conductive layer and passing through at least a part of the insulating film; and said first and second conductive layers are connected to first and second potentials, respectively, and a capacitor, which extends in the depth direction of said through hole, is formed by using said insulating inter-layer film interposed between said first conductive layer and said second conductive layer within said through hole.

Preferably, said through hole comprises a second through hole being electrically connected to a semiconductor region or a wiring region only at either of the opened ends thereof.

Preferably, said through-hole comprises a second through-hole opened to the surface of said insulating region formed on the surface of said substrate.

Preferably, said through-hole comprises a second through-hole opened to the surface of an element separation region formed on the surface of a semiconductor substrate as said substrate.

Preferably, said first conductive layer is formed within a first through-hole being separated by a predetermined distance from said through-hole, whereby a vertical capacitor, which extends in the depth direction of said through-hole, is formed by said first and second conductive layers and said insulating film interposed between said first and second conductive layers.

Preferably, said through-hole is rectangular in cross section, and the surface of said through-hole, which is confronted with said first conductive layer, is a wider surface.

Preferably, said through-hole comprises a third through-hole opened to the surface of said substrate so as to be electrically connected with the surface of said substrate, and a second through-hole opened to the surface of an insulating region formed on the surface of said substrate, said second and third through-holes being formed in the same manufacturing step, and the area of the opening of said second through-hole is larger than that of the opening of said third through-hole.

Preferably, said through-hole surrounds said first conductive layer while being separated a predetermined distance from the side wall of said first through-hole, and a vertical capacitor, which extends in the depth direction of said through-hole, is formed between the side wall of said first conductive layer and said second conductive layer, which are confronted with each other with said insulating film being interposed therebetween.

Preferably, said first conductive layer comprises an insulating protective layer formed on the side wall of said first conductive layer.

Preferably, said through-hole overlaps with at least a part of the upper surface of said first conductive layer, and a vertical capacitor, which extends in the depth direction of said through-hole, is formed between the side wall of said first conductive layer and said second conductive layer, which are confronted with each other with said insulating film being interposed therebetween.

Preferably, said first conductive layer comprises insulating protective films, which are formed on at least the side wall and the upper surface of said first conductive layer.

Preferably, said through-hole is opened to an areal range from the upper surface to both side walls of said first conductive layer.

Preferably, said insulating protective layer consists of a first insulating film and a second insulating film layered on said first insulating layer, said second insulating film having a permittivity smaller than that of said first insulating film and exhibiting etching resistance to the etching conditions of said insulating film.

Preferably, said first conductive layer surrounds the outside of said second conductive layer so as to be spaced a predetermined distance from said second conductive layer filled in said through-hole.

Preferably, said first conductive layer is formed in formed in a comb shape and said through-holes are formed at the positions sandwiched between the teeth of the comb.

Preferably, said first and second conductive layers are filled in said first and second through-holes, and the upper ends thereof are connected to said first and second conductive layers, and the spatial intervals in the arrays of said first and second conductive layers are smaller than those in the arrays of said first and second through-holes.

Preferably, said first and second conductive layers are filled in said first and second through-holes, and the upper ends thereof are connected to said first and second conductive layers, and the spatial intervals in the arrays of said first and second through-holes are smaller than those in the arrays of said first and second conductive layers.

Preferably, said first and second conductive layers are filled in said first and second through-holes, and the upper ends thereof are connected to said first and second conductive layers, and the spatial intervals in the arrays of said first and second through-holes are substantially equal to those in the arrays of said first and second conductive layers.

Preferably, wherein said first conductive layer is a gate electrode wiring, and said second through-hole is a source or drain contact hole, and said second conductive layer is a source or drain wiring.

Preferably, said first conductive layer is a gate electrode wiring, and said second through-hole is formed on both sides of said gate electrode wiring on an element isolation region, while being spaced a predetermined distance therefrom.

Preferably, said first conductive layer is a gate electrode wiring, and second through-hole is formed along said gate electrode wiring so as to cover said gate electrode wiring of which the surface is covered with an insulating protective film on the element separation region, wherein a vertical capacitor is formed by said gate electrode wiring, said insulating protective film covering said gate electrode wiring, and said second conductive layer within said second through-hole.

Preferably, said insulating protective layer is a multi-layer film.

Preferably, said second through-hole and said second conductive layer filled therein form a seal ring which is formed surrounding the peripheral edge of the surface of the semiconductor chip, and said first conductive layer is an auxiliary ring formed in said first through-hole in a state that it is spaced a predetermined distance from said seal ring while being arranged parallel to said seal ring, and said seal ring and said auxiliary ring form a vertical capacitor.

Preferably, said auxiliary ring is formed so as to electrically contact with said substrate.

Preferably, said auxiliary ring is connected with anyone of power source line and signal line.

Further second invention defines a method of manufacturing a semiconductor device comprising the steps of:

forming a desired element region in a semiconductor substrate;
forming a wiring layer on the surface of said semiconductor substrate; wherein
said wiring layer forming step comprises
a step of forming a first conductive layer,
a step of forming an insulating inter-layer film,
a step of forming a through-hole by selectively removing said insulating film, and
a step of forming a second conductive layer within said through-hole,
said through-hole forming step comprises a step for simultaneously forming a through-hole for circuit connection and a through-hole for forming a supplemental capacitor in which said first and second conductive layers within said through-hole are located close to each other,
wherein said first and second conductive layers are connected in part to first and second different potentials, thereby forming a capacitor.

Further third invention defines a method of manufacturing a semiconductor device comprising the steps of:

forming a desired element region in a semiconductor substrate;
forming a wiring layer on the surface of said semiconductor substrate;
said wiring layer forming step comprises
a step of forming a first conductive layer,
a step of forming an insulating inter-layer film,
a step of forming a through-hole by selectively removing said insulating inter-layer film, and
a step of forming a second conductive layer within said through-hole,
said through-hole forming step comprises a step for simultaneously forming a through-hole for circuit connection and a through-hole for forming a supplemental capacitor in which at least said second conductive layers within said through-hole are located close to each other,
wherein said second conductive layers within said supplemental capacitor are connected to first and second different potentials, thereby forming a supplemental capacitor.

Preferably, the method comprises the steps of:

a step of forming a gate electrode film and a gate electrode layer on the surface of a semiconductor substrate including an element separation region;
a step of forming a source-drain region;
a step of forming an insulating inter-layer film;
a step of forming a through-hole so that said through-hole is opened to said source-drain region by selectively etching said insulating inter-layer film in the vicinity of said electrode layer; and
a step of forming, by forming a conductive layer, a wiring so that said wiring comes in contact with said source and drain regions through said through hole,
said through-hole forming step comprises a step for simultaneously forming said through-hole and another through-hole for a supplemental capacitor at a position located near said gate electrode wiring running on said element separation region,
wherein said wiring and electrode layers are connected to first and second different potentials, respectively, whereby a supplemental capacitor is formed.

Preferably said electrode layer forming step comprises a step of covering said gate electrode with an insulating protective film after said gate electrode forming step.

The forth invention defines a method of manufacturing a semiconductor device comprising the steps of:

forming an insulating inter-layer film on the surface of a substrate including a desired element region;
forming a through-hole by selectively removing a contact hole for electrical connection and said insulating inter-layer film; and
forming a second conductive layer within said through-hole,

said through-hole forming step including a step of forming a plurality of second through-holes while being spaced from one another in order to simultaneously forming a contact region for making an electrical contact and a vertical capacitor,

whereby the adjacent regions of said second conductive layers are respectively connected to first and second potentials, thereby forming a capacitor

A semiconductor device defined in a first aspect is comprised of: a first conductive layer formed of a surface of a semiconductor substrate; a through hole being located close to the first conductive layer and passing through at least a part of an insulating inter-layer film; and a second conductive layer being filled in the through hole; wherein the first and second conductive layers are connected to first and second potentials, respectively, and a vertical capacitor, which extends in the depth direction of the through hole, is formed by using the insulating inter-layer film interposed between the first conductive layer and the second conductive layer within the through hole.

Namely, a supplemental capacitor is formed using the large capacitance between the wirings and that between the through-holes because of downsizing of the process technique. The inter-wiring capacitor and inter-through-hole capacitor can be arranged at any optional position within the semiconductor device so that the supplemental capacitor can be formed at a desired position. Therefore, in the semiconductor device in which an analog circuit and a digital circuit are mixedly formed or the semiconductor device operating at a low voltage, the supplemental capacitor can be easily formed in the vicinity of the area where switching noise is generated, thereby effectively realizing the countermeasure for power source noise. In the process technique with advanced downsizing, a capacitor having a large capacitance can be formed with a smaller area than the capacitor using the wirings. In addition, the capacitor can be formed in the same process as the other device such as a transistor without adding any special step and in the conventional process.

In the semiconductor device and the method of manufacturing a semiconductor device, after an electrode layer and an insulating inter-layer film are formed on a semiconductor substrate, an insulating layer on the semiconductor substrate or an insulating substrate, said insulating inter-layer film is etched to form a through-hole in the vicinity of said electrode layer, and a wiring electrically connected to the through-hole is formed on said through-hole, whereby said wiring and said electrode layer are connected to a first and a second potential, respectively to form a capacitor. Preferably, an insulating protective film is formed between the electrode layer and through-hole so that they are insulated from each other. The electrode layer may be e.g. a poly-Si layer.

In the semiconductor devicedefined in claim 4, an electrode layer and an insulating inter-layer film are formed on a semiconductor substrate, an insulating layer on the semiconductor substrate or an insulating substrate, said insulating inter-layer film is etched to form a first and a second through-hole in the vicinity of said electrode layer so as to sandwich the electrode layer, and wirings electrically connected to the first and the second through-hole are formed on the first and the second through-hole, whereby said wiring and said electrode layer are connected to a first and a second potential to form a capacitor. Preferably, an insulating protective film is formed between the electrode layer and through-hole so that they are insulated from each other. The electrode layer may be e.g. a poly-Si layer.

In the semiconductor device defined in claim 13, using the capacitance between the electrode layer and through-hole when said though-hole is formed to cover said electrode layer, a supplemental capacitor is formed, the supplemental capacitor having a larger capacitance can be formed at a desired position within the semiconductor device.

In the semiconductor device defined in claim 15, a supplemental capacitor is formed using the capacitance between the electrode formed to surround the through-hole and through-hole, the capacitor having a larger capacitance can be formed at a desired position within a semiconductor device. The patterns of the electrode layer formed to surround the through-hole may be registered in an apparatus for assisting design. Using these patterns alone or in combination, a supplemental capacitor having desired capacitance can be formed at a desired position.

In the semiconductor device defined in claim 16, said electrode layer is formed in a comb shape and said through-holes are formed at the positions sandwiched between the teeth of the comb. A supplemental capacitor is formed using the capacitance between the electrode layer and through-hole. Therefore, the capacitor having a larger capacitance can be formed at a desired position within a semiconductor device. The patterns of the electrode layer in a comb shape and through-holes formed at the positions sandwiched between the teeth of the comb may be registered in an apparatus for assisting design. Using these patterns alone or in combination, a supplemental capacitor having desired capacitance can be formed at a desired position.

In the semiconductor device defined in claim 10 , a first and a second electrode are formed on a semiconductor substrate, an insulating layer on the semiconductor substrate or an insulating substrate, and said first and said second electrode are connected to a first and a second potential to form a capacitor. Preferably, the side surface of each of the first and the second electrode or both side surface and the upper surfaces are covered with an insulating protective film for electrically insulating them from each other. The electrode layer (first and second conductive layers) may be e.g. a poly-Si layer, aluminum thin film, tungsten thin film, or metal silicide film.

In the semiconductor defined in claim 24, a seal ring is formed surrounding the peripheral edge of the surface of a semiconductor chip. An auxiliary ring is formed within a first through-hole disposed parallel to the seal ring while being spaced a predetermined distance from the seal ring. The seal ring and the auxiliary ring are connected to different potentials, respectively. As a result, a vertical capacitor is formed along the peripheral edge of the semiconductor chip and between the seal ring and the auxiliary ring. The resultant vertical capacitor has a large capacitance.

In the thus constructed invention, in the case that one of the seal ring and the auxiliary ring is used as a power source annular wiring. Therefore, extension of the wiring is lessened, freedom of layout is increased and further reduction of the chip area is realized.

Further in the case that one of the seal ring and the auxiliary ring is used as an auxiliary power source annular wiring, since the wiring is formed laterally, extension of the wiring is lessened, freedom of layout is increased and further large reduction of the chip area is realized and IR drop supression can be obtained .

Brief Description of the Drawings

Figs. 1(a) to 1(c) are views showing the portion where a capacitor of a semiconductor device according to the first embodiment of the invention is formed.

Figs. 2(a) to 2(c) are views explaining an element structure constituting an nMOS transistor in a semiconductor integrated circuit (No.1).

Figs. 3(a) to 3(c) are views explaining an element structure constituting an nMOS transistor in a semiconductor integrated circuit (No. 2).

Figs. 4(a) to 4(c) are views showing the portion where a capacitor of a semiconductor device according to the second embodiment of the invention is formed.

Figs. 5(a) to 5(e) are views for explaining the method for manufacturing a semiconductor device according to the second embodiment (No.1), and are sectional views after respective steps have been made.

Figs. 6(a) to 6(c) are views for explaining the method for manufacturing a semiconductor device according to the second embodiment (No.2) ( as sectional views after respective steps have been made).

Figs. 7(a) and 7(b) are views showing the portion where a capacitor of a semiconductor device according to the third embodiment of the invention is formed.

Fig. 8(a) and 8(b) are views showing the portion where a capacitor of a semiconductor device according to the fourth embodiment of the invention is formed.

Fig. 9(a) and 9(b) are views showing the portion where a capacitor of a semiconductor device according to the fifth embodiment of the invention is formed.

Fig. 10 is a view showing the portion where a capacitor of a semiconductor device according to the sixth embodiment of the invention is formed.

Fig. 11 is a view for explaining a model for calculating the parasitic capacitance in the semiconductor device according to the six embodiment.

Fig. 12 is a planar view showing a semiconductor device according to the seventh embodiment of the invention.

Figs. 13(a) to Fig. 13 (d) are views showing a semiconductor device according to the seventh embodiment of the invention

Figs. 14(a) and 14(b) are views showing a variation of the semiconductor device according to the seventh embodiment of the invention an another .

Fig. 15 is a conventional view showing a semiconductor device according to the seventh embodiment of the invention.

Description of the preferred Embodiments

Referring to the drawings, a detailed explanation will be given of the modes of carrying out a semiconductor device and a method of manufacturing it according to the invention in the sequence of Embodiment 1, Embodiment 2, Embodiment 3, Embodiment 4, Embodiment 5 , Embodiment 6 and Embodiment 7.

Prior to explaining the modes of carrying out a semiconductor device and a method of manufacturing it according to the invention, consideration is taken on a change in the element structure (structure in the wiring layer or polysilicon layer) due to downsizing of the process technique. Figs. 2 and 3 are views for explaining the element structure constituting the corresponding portion of a semiconductor integrated circuit (polysilicon gate nMOS transistor). Fig. 3 shows the element structure by more advanced downsizing of the process than the case of Fig. 2. Fig. 2(a) and Fig. 3(a) are plan views (pattern views); Fig. 2(b) and Fig. 3(b) are sectional views taken in line A - A' in Fig. 2(a) and Fig. 2(b), respectively, and Fig. 2(c) and Fig. 3(c) are sectional views taken in line B - B' in Fig. 2(a) and Fig. 2(c), respectively.

In Fig. 2, reference numeral 201 denotes a p-type silicon (Si) substrate; 211 a gate oxide film; D21 an n+ diffused layer; P21 a poly-Si layer; B21, B22 and B23 a through-hole, (in these embodiments through hole shows a hole in which a conductive layer is formed) respectively; M21, M22 and M23 a metallic wiring of a first wiring layer; and M24 a metallic wiring of the second wiring layer.

In Fig. 3 also, reference numeral 301 denotes a p-type Si layer;
311 a gate oxide film; 312 an insulating protective film for separating a through-hole and a poly-Si layer from each other in a SAC (Self-Aligned Contact); D31 an n+ diffused region; P31 a poly-Si layer; B31, B32 and B33 a through-hole, respectively; M31, M32 and M33 a metallic wiring of a first wiring layer; and M34 a metallic wiring of the second wiring layer.

From the comparison between Fig. 2(c) and Fig. 3(c), it can be seen that with development of downsizing of the process technique, the dominant capacitance has changed from the capacitance the wirings between the different wiring layers of the first and the second wiring layer (e.g. between the metallic wiring M24 and the metallic wiring M22, M23 in Fig. 2(c)) to that between the wirings on the same wiring layer (e.g. between the metallic wirings M32 and M33). This is attributable to that with development of downsizing of the process technique, the distance between the wirings on the same wiring layer has been shortened and the thickness of the wiring layer has been increased to increase the sectional area of the wiring for the purpose of suppressing an increase in the resistance.

From the comparison between the Figs. 2(b) and 2(c), it can be seen that while the capacitance between the through-holes or between the through-hole and the poly-Si layer have not been considered problematic in Fig. 2(b), with development of downsizing of the process technique, the capacitance between the through-holes B31 and B32 or that between the through-holes B31, B32 and the poly-Si layer 31 has a fairly large value in Fig. 3(b). Particularly, the capacitance between the through-hole and poly-Si layer has a larger capacitance because the insulating protective film 312 has high permittivity.

In this way, because of the change in the structure of the wiring layer and poly-Si layer resulted from downsizing of the process technique, the supplemental capacitors between the wirings on the same wiring layer and between the through-hole and the poly-Si layer have become have large values. The downsizing process technique has proposed several countermeasures for dealing with such supplemental capacitor. In accordance with the semiconductor device and a method of manufacturing it, using the structural portion having a large supplemental capacitance because of downsizing of the process technique, the capacitor added to a power source wiring for countermeasure against power source noise or the capacitor constituting a semiconductor integrated circuit are formed.

[Embodiment 1]

Fig. 1 is a view showing the portion where a capacitor of a semiconductor device according to the first embodiment of the invention. Figs. 1(a) and 1(c) are plan views (pattern views) and Fig. 1(b) is a sectional view taken in line A - A' in Figs. 1(a) and 1(c). The semiconductor device and method of manufacturing it according to this embodiment intend to form a supplemental capacitor using a capacitance between wirings and through-holes having large capacitance with downsizing of a process technique.

In Fig. 1, reference numeral 101 denotes a silicon substrate, B11 and B12 denote a through-hole, respectively and M11 and M12 denote metallic a wiring, respectively. Although not shown in Fig. 1(b), an insulating inter-layer film made of $SiO_2$ (permittivity:4.2) of 200-600nm thick is formed between the through-holes B11 and B12, and a metallic inter-wiring film made of SiOF(permittivity:3.7) of 50-500nm thick is formed between the metallic wirings M11 and M12.

Where the structure shown in Fig. 1 is used as an supplemental capacitor to power source wirings for the countermeasure against power source noise, one of the metallic wirings is connected to a power source potential VDD and the other is connected to another power source potential. Further, where it is used as a capacitor in a semiconductor integrated circuit, the metallic wirings M11 and M12 have a potential across both ends of the capacitor.

The structure shown in Fig. 1 can be realized at least through the following process. To start with, an insulating inter-layer film of 200-600nm thick, made of $SiO_2$, is formed on a silicon substrate 101 by a CVD process. Then, the insulating inter-layer film is etched using a resist pattern formed in a photolithography process as a mask, and filled with an aluminum thin film by a metal thin film forming process using a low pressure CVD process, whereby forming through-holes B11 and B12 on the silicon substrate 101. Further, an aluminum thin film is formed by a metal thin film forming process (wiring forming step) using a low pressure CVD process, so that metallic wirings M11 and M12 are formed on the through-holes B11 and B12, respectively. A thickness of the metal film was approximately 50-500nm thick on the flat surface. The metal thin film to be filled in the through-holes and the metallic wirings may be formed in one process step. It is readily understood that the film forming process is not limited to the low pressure CVD process, but may be sputtering process, Damascene Metallization step process or the like instead of the former.

Where a capacitor is realized by the structure shown in Figs. 1(a) and 1(b), the capacitance of the capacitor is a sum of the capacitance between the wirings and the capacitance between the through-holes. However, according to the magnitude relationship among the film thickness $h_m$ of the metallic wirings M11 and M12, height of the through-holes B11 and B12 and distance db between the through-holes B11 and B12, either one of the capacitance between the wirings and the capacitance between the through-holes is more dominant.

First, where the height hb of the through-holes is larger than the distance between the through-holes (db < hb), the capacitance between the through-holes can be effectively used. On the other hand, the distance db between the through-holes is larger than the height of through-holes (db > hb), the capacitance between the wirings is more dominant. However, this does not mean that the capacitance between the through-holes is not used.

For example, the distance db between the through-holes is preferably 50-500nm. More preferably the distance is as near as possible. The distance dm between the metallic wirings M11 and M12 is preferably 50-500nm. More preferably the distance is as near as possible.

Further, the insulating inter-layer film can be made of a film having a high permittivity and the insulating inter-wiring film can be made of a film having a low permittivity. Thereby the capacitance between the through-holes and the capacitance between the wirings can be epualized. Further by laminating a plurality of films having different film quality from each other, better dielectric characteristics can be obtained.

Where the height hb of the through-holes is larger than the film thickness of the metal wirings (hb > hm), the capacitance between the through-holes is greater than the capacitance between the wirings and hence can be effectively used. In the contrary case (hb < hm), the capacitance between the wirings is greater than the capacitance between the through-holes. However, this does not means that the capacitance between the through-holes is not used. In this case, by modulating a form of through-hole within a allowable pattern layout so as to make a facing area larger, the capacitance between the through-holes can be made large.

In the present process technique, thinning the insulating inter-layer film increases the wiring capacitance of the entire circuit, thereby exerting an influence on the entire circuit. Therefore, as long as there is not a problem relative to a process technique, the insulating inter-layer film is desired to be laminated thicker. Thus, in most cases, from the standpoint of structure, it is considered that db < hb and hb > hm.

This embodiment of the invention has been explained on the assumption of a MOS device. However, it is needless to say that the invention can be applied to other devices such as a bipolar device. Further, although the through-holes B11 and B12 were formed on the silicon substrate 101, they may be formed on the insulating layer such an element isolation region. Moreover, using an insulating layer in place of the silicon substrate, this embodiment of the invention can be applied to a SOI (Silicon On Insulator) structure. hole The through-holes B11 and B12 generally have a fixed square shape in section as shown in Fig. 1(a). However, where a supplemental capacitor is formed, since through-holes are formed on a semiconductor substrate, an insulating layer thereon or an insulating substrate, the problem such as fluctuation of etching does not occur. Therefore, the rule of the fixed shape of the through-hole may be disregarded so that the through-holes has a rectangular shape in section as shown in Fig. 1(c).Thereby an area of capacitor is increased and a large capacitance can be obtained. And by use of capacitance along a through hole depth direction, such a large capacitance can be obtained without increasing an occupied area.

As described above, in the semiconductor device and a method of manufacturing it according to this embodiment of the invention, a supplemental capacitor is formed using the large capacitance between the wirings (M11 and M12) and that between the through-holes (B11 and B12) because of downsizing of the process technique so that it can be formed at a desired position within the semiconductor device. For example, in the semiconductor device in which an analog circuit and a digital circuit are mixedly formed or the semiconductor device operating at a low voltage, the supplemental capacitor can be easily formed in the vicinity of the area where switching noise is generated, thereby effectively realizing the countermeasure for power source noise. In the process technique with advanced downsizing, a capacitance having large capacitance can be formed with a smaller area than the conventional parallel-plate type capacitor between the wiring layers In addition, the capacitor can be formed in the same process as the other device such as a transistor without adding any special step.

[Embodiment 2]

Fig. 4 is a view for explaining the capacitor of a semiconductor device according to the second embodiment of the invention. Figs. 4(a) and 4(c) are plan views (pattern views). Fig. 4(b) is a sectional view taken in line A - A' in Figs. 4(a) and 4(c). Incidentally, the semiconductor device and method of manufacturing it according to this embodiment intend to form a supplemental capacitor using a capacitor between a through-hole and a poly-silicon layer having large capacitance with downsizing of the process technique.

In Fig. 4, reference sign 401 denotes a silicon substrate; B41, B42 and B43 a through-hole, respectively; M41 and M42 a metallic wiring of 50-500mm thick of aluminum film, respectively; and P41 a polysilicon(poly-Si) layer of 200-600mm thick. Further the through-holes B41, B42 and B43 are filled with the polysilicon(poly-Si) layer formed in the same step of the wiring P41. A spacer 411 made of $SiO_2$ is formed on the side of the poly-Si layer 41 and its side face and upper face are covered with an insulating protection film 412 made of SiN. Although not shown in Fig. 4(b), an insulating inter-layer film is formed between the though-holes B41 and B42, and an insulating inter-wiring film is formed between the metallic wirings M41 and M42.

In this embodiment, the silicon substrate 401 and the poly-Si layer within the through holes B41 and B42 are not electrically contacted. The wiring M42 is connected with the wiring P41 formed on the silicon substrate 401 by through hole B43. Further the through-holes B41, B42 and B43 are filled with the polysilicon(poly-Si) layer made of the same material as the wiring P41.

Where the structure shown in Fig. 4 is used as an supplemental capacitor to power source wirings for the countermeasure against power source noise, one of the metallic wirings M41 and M42 is connected to a power source potential VDD and the other is connected to another power source potential VSS. Further, where it is used as a capacitor in a semiconductor integrated circuit, the metallic wirings M41 and M42 have a potential across both ends of the capacitor.

In Fig. 4(a), all of the through-holes B41, B42 and B43 have same forms one another, only one through-hole B43 is electrically contacted with the poly-Si P41. And the through-holes B41, B42 are used for forming capacitors and therefore they are electrically contacted with none of wirings formed on the Si-substrate 401.

Contrary that, in Fig. 4(c), although the through-hole B43 being contacted with the poly-Si P41 has regular square form wiring, the through-holes B41, B42 used for forming capacitors have a rectangular cross sections so as to increase an area facing to the poly-Si P41.

In Fig. 4, although the through-holes B41, B42 and poly-Si layer P41 ware formed on the Si substrate 401, they may be formed on the insulating layer such an element isolation region of the Si substrate 401. Moreover, using an insulating substrate in place of the silicon substrate, this embodiment of the invention can be applied to a SOI (Silicon On Insulator) structure.

In Fig. 4, although a capacitor is formed using the capacitance between the two though-holes B41, B42 and poly-Si layer P41, it may be formed between one through-hole B41 or B42 and the poly-Si layer P41. In Fig. 4, the capacitance of the capacitor is determined by the sum of the capacitances between the left side surface of the poly-Si layer P41 and the through-hole B41, between the upper surface of the poly-Si layer B41 and the through-hole B41, between the right side surface of the poly-Si layer B41 and through-hole B42 and between the upper surface of the poly-Si layer P41 and the through-hole B42. However, where the capacitor is formed in this modified structure, its capacitance is the sum of the capacitances between the side surface of the poly-Si layer P41 and the through-hole and between the upper surface of the poly-Si layer P41 and the through-hole.

The through-holes B41 and B42 generally have a fixed square shape in section as shown in Fig. 4(a). However, where a supplemental capacitor is formed, since through-holes are formed on a semiconductor substrate, an insulating layer thereon or an insulating substrate, the problem such as fluctuation of etching does not occur. Therefore, the rule of the fixed shape of the through-hole may be disregarded so that the through-holes has a rectangular shape in section as shown in Fig. 4(c).

Referring to Figs. 5 and 6, an explanation will be given of a method of manufacturing a semiconductor device according to this embodiment, i.e. a method of manufacturing a capacitor using the capacitance between the through-hole and the poly-Si layer. Fig. 5(a)-(e) and Fig. 6(a)-(c) are sectional views after the respective manufacturing steps have been effected. In Figs. 5 and 6, both areas where a supplemental capacitor and a transistor are formed are shown. The supplemental capacitor formed in an element isolation region of the silicon substrate is shown.

First, Fig. 5(a) is a sectional view after a gate oxide film 504 is formed in a p-type Si substrate 501, and an n-well 502 and a p-well 503 have been formed.

Fig. 5(b) is a sectional view after an element isolation region 505 such as STI (Shallow Trench Isolation). The element isolation region 505 is an insulating film such as silicon oxide. As described later, a capacitor is formed on the element isolation region 505 and a transistor is formed on the side of the n-well 502.

As shown in Fig. 5C, after poly-Si is deposited by a low pressure CVD process, gate electrodes (poly-Si layers) P51, P52 and P53 are formed by a lithography process. An n-LDD implanting region 506 is formed, by ion implantation, outside an $n^+$ diffusion region 507 which will serve as a source-drain while using those gate electrodes as a mask. Here, it is desirable that on-gate cap film C51, C52 and C53 as silicon nitride films are formed on the gate electrodes, respectively. If so done, when the mask will dislocate during the process of removing the silicon oxide films of the contact portions, those on-gate cap films C51, C52 and C53 operate as etching stoppers to prevent the gate electrodes from being exposed. Here, the term "LDD" means an LDD (lightly doped drain) structure in which an $n^-$ region 506 is formed outside the $n^+$ diffusion region 507 to lessen the electric field and to give hot electrons resistance.

Then, as shown in Fig. 5D, a silicon oxide film is formed on the front side of the structure by a CVD process. Thereafter, spacers 511 are formed by an anisotropic etching process, while leaving the silicon oxide film on only the side walls of the poly-Si layers P51, P52 and P53. Following this, an n+ diffusion region 507 is formed by an ion implantation process using the spacers 511 and the gate electrodes P53 as a mask. Here, the spacers 511 is protective films made of oxide silicon $SiO_2$ (permittivity of 4.2) or the like.

Subsequently, as shown in Fig. 5E, an insulating protective film 512 for SAC process is formed over the entire surface of the structure. Silicon nitride SiN (its permittivity is 6.5) or the like is used for the insulating protective film 512. That is, it is desirable that a film preferable for the insulating protective film is high in insulation, etching resistance and permittivity. The insulating protective film may be formed in two layer films, e.g., a silicon nitride film and a silicon oxide film, by dividing the insulating protective film in its thickness direction as indicated by a broken line 510.

Fig. 6(a) is a sectional view after an insulating inter-layer film 513 has been formed by coating method so as to have a 200-600nm thickness. The insulating inter-layer film 513 may be a film having comparatively low permittivity such as SiOF (permittivity of 3.7), $SiO_2$ (permittivity of 4.2) and HSQ (Hydrogen Silsesquioxane; permittivity of 3.0).

Fig. 6(b) is a sectional view after the insulating inter-layer film 513 is etched to form through-holes B51, B52, B53, B54 and B55 and a conductive material is embedded in these through-holes. Now, it is assumed that when the thickness of the insulating protective film 512 is t and the height of the through-holes B51 - B55 is hb, the etching rate Ra of the insulating protective film 512 is smaller than (hb/t) times of the etching rate Rb of the insulating inter-layer film 513. The etching rate represents easiness of reduction, and the etching rate depends on a material so that the thickness t of the insulating protective film can be substantially determined.

Fig. 6(c) is a sectional view after wirings M51 - M55 have been formed by CVD process on the surface on which the corresponding through-holes B51 - B55 are formed in $SiO_2$ as an inter-wiring films 514. Through the process described above, the capacitor is formed on the element isolation region 505 by generating capacitance between the gate wirings P51-52 formed on the element isolation region 505 and conductive layer in the through-holes B51-53, and the transistor is formed on the side of the n-well 502. As understood from the description, the capacitor can be formed in the same process as the other device such as a transistor without adding any special step and increasing the occupied area.

As described above, in the semiconductor device and a method of manufacturing it according to this embodiment of the invention, a supplemental lateral typed capacitor is formed using large capacitance between the poly-Si layer and the through-hole because of downsizing of the process technique so that it can be formed at a desired position within the semiconductor device. For example, in the semiconductor device in which an analog circuit and a digital circuit are mixedly formed or the semiconductor device operating at a low voltage, the supplemental capacitor can be easily formed in the vicinity of the area where switching noise is generated, thereby effectively realizing the countermeasure for power source noise. In the process technique with advanced downsizing, a capacitance having large capacitance can be formed with a smaller area than the conventional parallel-plate type capacitor between the wiring layers. In addition, the capacitor can be formed in the same process as the other device such as a transistor without adding any special step.

This embodiment of the invention has been explained on the assumption of a MOS device. However, it is needless to say that the invention can be applied to other devices such as a bipolar device.

[Embodiment 3]

Fig. 7 is a view for explaining the capacitor of a semiconductor device according to the third embodiment of the invention. Figs. 7(a) is a plan view (pattern view). Fig. 7(b) is a sectional view taken in line A - A' in Fig. 7(a). In the semiconductor device and a method of manufacturing it according to this embodiment, as in the case of the second embodiment, a supplemental capacitor is formed using the capacitance between the through-hole and poly-Si layer such as a gate electrode wiring etc. However, this embodiment is different in that the though-hole is formed to cover the poly-Si layer.

In Fig. 7, reference sign 701 denotes a Si substrate; B71, B72 a through-hole; M71, M72 a metallic wiring; and P71 a poly-Si layer. On the side of the poly-Si layer P71, a spacer 711 of $SiO_2$ is formed, and its side surface and upper surfaces are covered with an insulating protective film 712 of SiN.

Where the structure shown in Fig. 7 is used as an supplemental capacitor to power source wirings for the countermeasure against power source noise, one of the metallic wirings M71 and M72 is connected to a power source potential VDD and the other is connected to another power source potential VSS. Further, where it is used as a capacitor in a semiconductor integrated circuit, the metallic wirings M71 and M72 have a potential across both ends of the capacitor.

The structure having the structure as shown in Fig. 7 can be formed in the same manner as in the second embodiment, and can be realized at least in the following process. First, in CVD process, a poly-Si layer P71 is formed on a Si substrate 701 and patterned as an electrode wiring by photolithograpy process. Next, in a step of forming an insulating protective film, a spacer 711 is formed on the side of the poly-Si layer P71 and an insulating protective film 712 is formed to cover it. In a step of forming an insulating inter-layer film, the insulating inter-layer film is formed. In a step of forming a through-hole, the insulating inter-layer film is etched to form a though-hole 71. The through-hole B71 is formed to have a cutting plane having a size enough to cover the poly-Si layer P71. Further, in a step of forming a wiring, metallic wirings M71 and M72 are formed on the through-holes B71 and B72. Therefore, as an entire upper and side surface of the poly-Si P71 is used as a capacitor electrode, the supplemental capacitor according to this embodiment can have a larger capacitance than that in the second embodiment.

The through-hole generally has a fixed square shape in section like the through-hole B72. However, where a supplemental capacitor is formed, since through-holes are formed on a semiconductor substrate, an insulating layer thereon or an insulating substrate, the problem such as fluctuation of etching does not occur. Therefore, the rule of the fixed shape of the through-hole may be disregarded so that the through-hole has a rectangular shape like the through-hole B71.

This embodiment of the invention has been explained on the assumption of a MOS device. However, it is needless to say that the invention can be applied to other devices such as a bipolar device. Further, in Fig. 7, although the through-hole B71 and poly-Si layer P71 were formed on the Si substrate 701, they may be formed on the insulating layer such an element isolation region of the Si substrate 701. Moreover, using an insulating substrate in place of the silicon substrate, this embodiment of the invention can be applied to a SOI (Silicon On Insulator) structure.

As described above, in the semiconductor device and a method of manufacturing it according to this embodiment of the invention, a supplemental capacitor is formed using the capacitance between the poly-Si layer and through-hole when the through-hole B71 has been formed to cover the poly-Si layer P71 so that a capacitor having a large capacitance can be formed at a desired position within the semiconductor device. For example, in the semiconductor device in which an analog circuit and a digital circuit are mixedly formed or the semiconductor device operating at a low voltage, the supplemental capacitor having large capacitance can be easily formed in the vicinity of the area where switching noise is generated, thereby effectively realizing the countermeasure for power source noise. In the process technique with advanced downsizing, a capacitance having larger capacitance can be formed. In addition, the capacitor can be formed in the same process as the other device such as a transistor without adding any special step.

[Embodiment 4]

Fig. 8 is a view for explaining the capacitor of a semiconductor device according to the fourth embodiment of the invention. Figs. 8(a) is a plan view (pattern view). Fig. 8(b) is a sectional view taken in line A - A' in Fig. 8(a). In the semiconductor device and a method of manufacturing it according to this embodiment, as in the case of the second embodiment, a supplemental capacitor is formed using the capacitance between the through-hole and poly-Si layer. However, this embodiment is different in that the poly-Si layer constitutes an electrode wiring is formed to surround the through-hole.

In Fig. 8, reference sign 801 denotes a Si substrate; B81, B82 a through-hole; M81, M82 a metallic wiring; and P81 a poly-Si layer. On the side of the poly-Si layer P81, a spacer 811 is formed, and its side surface and upper surface are covered with an insulating protective film 812. Although not shown in Fig. 8(b), an insulating inter-layer film is formed around the through-hole B81.

Where the structure shown in Fig. 8 is used as an supplemental capacitor to power source wirings for the countermeasure against power source noise, one of the metallic wirings M81 and M82 is connected to a power source potential VDD and the other is connected to another power source potential VSS. Further, where it is used as a capacitor in a semiconductor integrated circuit, the metallic wirings M81 and M82 have a potential across both ends of the capacitor. The structure shown in Fig. 8 can be manufactured by the process as in the second and the third embodiment.

This embodiment of the invention has been explained on the assumption of a MOS device. However, it is needless to say that the invention can be applied to other devices such as a bipolar device. Further, in Fig. 8, although the through-hole B81 and poly-Si layer P81 were formed on the Si substrate 801, they may be formed on the insulating layer such an element isolation region of the Si substrate 801. Moreover, using an insulating substrate in place of the silicon substrate, this embodiment of the invention can be applied to a SOI (Silicon On Insulator) structure.

In Fig. 8, the poly-Si layer P81 has a planar shape formed along the respective side of an octagon so as to surround the through-hole B81. In the case that the poly-Si layer P81 has a regular squre shape, a destance between the poly-Si layer P81 and the through-hole B81 at each edge portion of the regular squre. Therefore according to the octagon shape,each edge portion of the regular squre is made close to the through-hole B81. This shape can be realized in only a process rule in which the wiring of 45 degree on the skew of the right and left side is permitted. Where the wiring on the skew is not permitted, the planar shape of the poly-Si layer P81 may be modified into the shape formed along the respective sides of a square. The planar shape of the poly-Si layer may be not the shape surrounding all the directions of the through-hole B81, but the shape partially surrounding the through-hole B81, e.g. a コ-shape. In the case, it is also preferable that inner edge of the poly-Si layer P81 is formed along the outer side of the through hole.

As described above, in the semiconductor device and a method of manufacturing it according to this embodiment of the invention, a supplemental capacitor is formed using the capacitance between the poly-Si layer and through-hole when the poly-Si layer B81 is formed to surround the poly-Si layer P81. Therefore, the capacitor having a large capacitance can be formed at a desired position within the semiconductor device. Further, the effects of effectively realizing the countermeasure for power source noise and capability of forming a capacitor in the same process as the other device are the same as in the other embodiments.

Moreover, in this embodiment, the various patterns of poly-Si layer formed along the respective sides of an octagon and a square and "コ-shape may be registered as a single cell in a library of arranging/wiring tool (apparatus for assisting design of a semiconductor IC). Using these patterns alone or in combination, a supplemental capacitor having desired capacitance can be formed at a desired position. This is can be applied to a semiconductor device with more regular arranging/wiring such as a gate array.

[Embodiment 5]

Fig. 9 is a view for explaining the capacitor of a semiconductor device according to the fifth embodiment of the invention. Figs. 9(a) is a plan view (pattern view). Fig. 9(b) is a sectional view taken in line A - A' in Fig. 9(a). In the semiconductor device and a method of manufacturing it according to this embodiment, as in the case of the second embodiment, a supplemental capacitor is formed using the capacitance between the through-hole and poly-Si layer. However, this embodiment is different in that the poly-Si layer is formed in a comb shape and through-holes are formed at the positions sandwiched between the teeth of the comb.

In Fig. 9, reference sign 901 denotes a Si substrate; B91m-B9jm and B91p-B9j+1p a through-hole;M92, M92 a metallic wiring; and P91 - P9j+1 a poly-Si layer. The poly-Si layers P91 - P9j+1 are connected to one other by the poly-Si layer shown in Fig. 9(a) under the metallic wiring M92. A spacer 411 is formed on the side of each poly-Si layer and its side face and upper face are covered with an insulating protection film 912. Although not shown in Fig. 9(b), an insulating inter-layer film is formed around each of the through-holes B91m - B9jm.

Where the structure shown in Fig. 9 is used as an supplemental capacitor to power source wirings for the countermeasure against power source noise, one of the metallic wirings M91 and M92 is connected to a power source potential VDD and the other is connected to another power source potential VSS. Further, where it is used as a capacitor in a semiconductor integrated circuit, the metallic wirings M91 and M92 have a potential across both ends of the capacitor. The structure shown in Fig. 9 can be realized in the same process as in the second embodiment.
In Fig. 4, although the through-holes B91m - B9jm and poly-Si layer P91 - P9j+1 were formed on the Si substrate 901, they may be formed on the insulating layer such an element isolation region of the Si substrate 901. Moreover, using an insulating substrate in place of the silicon substrate 901, this embodiment of the invention can be applied to a SOI (Silicon On Insulator) structure. This embodiment can also be applied to not only the MOS device but also the other device.

As described above, in the semiconductor device and a method of manufacturing it according to this embodiment of the invention, a supplemental capacitor is formed using the capacitance between the poly-Si layer and through-hole when the poly-Si layer is formed in a comb shape and through-holes are formed at the positions sandwiched between the teeth of the comb. Therefore, the capacitor having large capacitance can be formed at a desired position within the semiconductor device. Further, the effects of effectively realizing the countermeasure for power source noise and capability of forming a capacitor in the same process as the other device are the same as in the other embodiments.

In Fig. 9, each of the through-holes B91m - B9jm is surrounded like "コ" by the poly-Si layer. However, the pattern of the capacitor according to the second embodiment may be successively arranged (i.e. there is no poly-Si under the metallic wiring M91 in Fig. 9). Moreover, in this embodiment, the various patterns of the poly-Si layer such as "コ"-shape and "エ"-shape may be registered as a single cell in a library of arranging/wiring tool (apparatus for assisting design of a semiconductor IC). Using these patterns in successive combination, a supplemental capacitor having desired capacitance can be formed at a desired position. This is can be applied to a semiconductor device with more regular arranging/wiring such as a gate array.

[Embodiment 6]

Fig. 10 is a view for explaining the capacitor of a semiconductor device according to the sixth embodiment of the invention. Figs. 10(a) is a plan view (pattern view). Fig. 10(b) is a sectional view taken in line A - A' in Fig. 10(a). The semiconductor device and method of manufacturing it according to this embodiment intend to form a supplemental capacitor using a capacitor between poly-Si layers which has acquired larger capacitance with downsizing of a process technique.

In Fig. 10, reference sign 1001 denotes a Si substrate; B101 - B102 a through-hole; M101, M102 a metallic wiring; and P101, P102 a poly-Si layer. A spacer 1011 is formed on the side of each poly-Si layer P101, P102 and its side face and upper face are covered with an insulating protection film 1012. Although not shown in Fig. 10(b), an insulating inter-layer film is formed above the insulating protective film 1012.

Where the structure shown in Fig. 10 is used as an supplemental capacitor to power source wirings for the countermeasure against power source noise, one of the metallic wirings M101 and M102 is connected to a power source potential VDD and the other is connected to another power source potential VSS. Further, where it is used as a capacitor in a semiconductor integrated circuit, the metallic wirings M101 and M102 have a potential across both ends of the capacitor. In Fig. 10, although the poly-Si layers P101 and P102 were formed on the Si substrate 1001, they may be formed on the insulating layer such an element isolation region of the Si substrate 1001. Moreover, using an insulating substrate in place of the silicon substrate 1001, this embodiment of the invention can be applied to a SOI (Silicon On Insulator) structure. This embodiment can also be applied to not only the MOS device but also the other device.

Further, in Fig. 10, although a capacitor was formed using the capacitance between the two poly-Si layers P101 and P102, it may be formed using the capacitance among three or more poly-Si layers. Fig. 11 is a sectional view where the capacitor is formed using the capacitance among three poly-Si layers P101, P102 and P103. In Fig. 11, reference sign 1005 denotes an element isolation region; and 1013 denotes an insulating inter-layer film. A parasitic capacitance can be represented in a formula paying attention to the poly-Si layer P102 at the center among the three poly-Si layers P101, P102 and P103.

It is assumed that the dielectric constant in vacuum is $\varepsilon 0$, that of the insulating inter-layer film 1013 is $\varepsilon A$, that of the insulating protective film 1012 is $\varepsilon B$, that of the element isolation region is $\varepsilon C$, distance between the poly-Si layers is d, height of the poly-Si layer is h, length of the parallel plates of the poly-Si layer, width of each poly-Si layer is w, film thickness of the insulating inter-layer film 1013 above the poly-Si layers is ht1, film thickness of the insulating protective film 1012 above the poly-Si layers is ht2, and film thickness of the element isolation region 1005 is hu. Then, the parasitic capacitance CP102 generated in the poly-Si layer P102 can be expressed by

$$CP102 = \varepsilon 0 \bullet w \bullet L/\{(ht1/\varepsilon A) + (ht2/\varepsilon B)\} + 2 \bullet \varepsilon B \bullet \varepsilon 0 \bullet (h \bullet L/d) + \varepsilon C \bullet \varepsilon 0 \bullet (w \bullet L/hu)$$

Now, it is assumed that the fringe capacitance which is generated on the periphery of the poly-Si layer P102 at issue is contained in the capacitance of the left and right and upper and lower parallel plates and the underlying well the element isolation region 1005 is located at a different potential from that at the poly-Si layer P102.

The structure as shown in Fig. 7 can be manufactured in the same manner as in the second embodiment, and can be realized at least in the following process. First, in a step of forming an electrode layer, poly-Si layers P101, P102 are formed on a Si substrate 1001. Next, in a step of forming an insulating protective film,a spacer 1011 is formed on the side of each of the poly-Si layers P101, P102 and an insulating protective film 1012 is formed to cover it. In a step of forming an insulating inter-layer film, the insulating inter-layer film is formed. In a step of forming a through-hole, the insulating inter-layer film is etched to form though-holes B101, B102. Further, in a step of forming a wiring, metallic wirings M101 and M102 are formed on the through-holes B101 and B102. Since the poly-Si layers are formed with high processing accuracy, the supplemental capacitor having an accurate capacitance can be formed.

As described above, in the semiconductor device and a method of manufacturing it according to this embodiment of the invention, a supplemental capacitor is formed using large capacitance between the poly-Si layers because of downsizing of the process technique so that it can be formed at a desired position within the semiconductor device. For example, in the semiconductor device in which an analog circuit and a digital circuit are mixedly formed or the semiconductor device operating at a low voltage, the supplemental capacitor can be easily formed in the vicinity of the area where switching noise is generated, thereby effectively realizing the countermeasure for power source noise. In the process technique with advanced downsizing, a capacitor having large capacitance can be formed with a smaller area than the conventional parallel-plate type capacitor between the wiring layers. In addition, the capacitor can be formed in the same process as the other device such as a transistor without adding any special step.

[Seventh Embodiment]

Figs. 12 and 13 are diagrams showing a semiconductor device according to a seventh embodiment of the present invention. Fig. 12 is a partial plan view (pattern diagram) showing a semiconductor wafer, and Fig. 13 is a diagram showing a key portion of the Fig. 12 semiconductor wafer. Fig. 13B is a cross sectional view taken on line X - X' in Fig. 13A; Fig. 13C is a cross sectional view taken on line X1 - X2' in Fig. 13A; and Fig. 13D is a cross sectional view showing taken on line Y - Y' in Fig. 13A. The semiconductor device of the embodiment shown in Fig. 13 is designed to have a double structure. In the figures, BP is a bonding pad, and CR is a chip area.

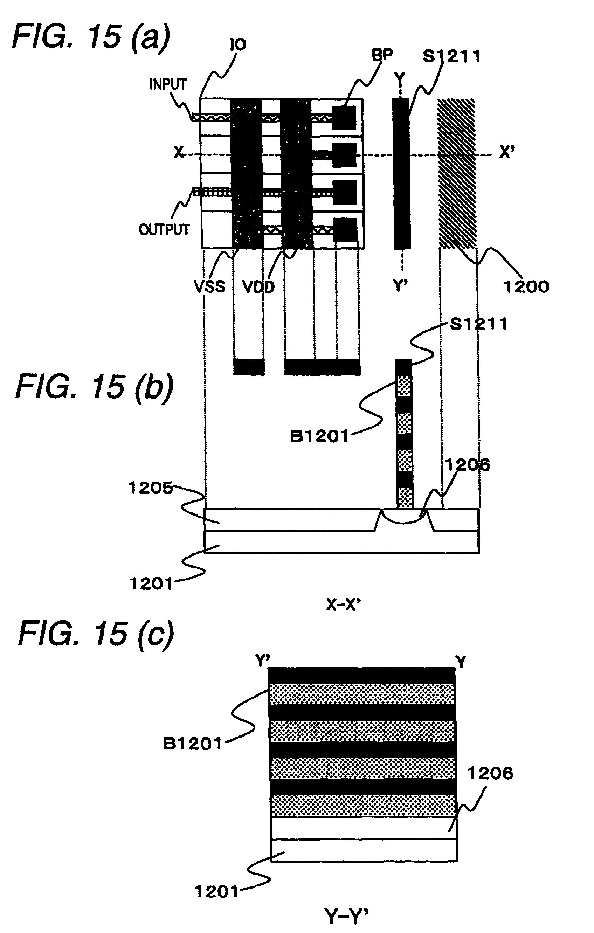

Before proceeding with description of the present embodiment, a conventional semiconductor will be described for the comparison purpose. Fig. 15 is a cross sectional view showing taken on line X- X' in Fig. 15A. Fig. 15B is a cross sectional view taken on line X - X' in Fig. 15A, and Fig. 15C is a cross sectional view taken on line Y - Y' in Fig. 15A. As seen from Fig. 15, in the conventional semiconductor chip, in order to fix the substrate potential at the peripheral edge of the semiconductor chip, a seal ring S1211 is provided surrounding the entire peripheral edge of the chip. In the semiconductor chip, semiconductor elements (not shown) are each formed in an element region enclosed by an element separation region 1205 being formed on the surface of a p-type silicon substrate 1201. A seal ring S1211 is formed on the outermost side of the device structure so as to come in contact with the p-type silicon substrate 1201 through a p-type impurity diffusion region 1206. In the figure, reference numeral 1200 designates a scribe lane 1200, which is a region to be removed in a dicing process.

As seen from the comparison of Figs. 13 and 15, in the semiconductor device of the invention, the seal ring formed on the peripheral edge of the semiconductor chip is double structured. The seal ring S1211, which is formed in each through-hole B1202 located on the outermost side, is connected to the potential $V_{DD}$. An auxiliary ring S1212, which is formed on the inner side of the through-holes B1202, is connected to the potential $V_{SS}$. An insulating inter-layer film present between the through-holes B1202 and B1202 is used as a capacitor insulating film C1200. A vertical capacity formed is thus structured.

Capacitance of the capacitor may be increased by using an insulating film of high permittivity for only the seal ring forming portion. The auxiliary ring S1212 comes in contact with an n-well region 1202 formed in the surface region of the p-type silicon substrate, through an n-type impurity diffusion region 1207.

The seal ring and auxiliary ring are almost entirely formed around the peripheral edge of the element region of the semiconductor chip. Therefore, if it is used as a power source line, a length of the power source line wired in the element region is reduced. As a result, an IR drop is lessened. The auxiliary ring S1212 is connected to the Vss wiring, but it is disconnected in the connection region of the outside seal ring, and the auxiliary ring S1212 is uniform in same potential over its entire length in the upper or lower layer wiring.

In a manufacturing stage, it suffices that in the seal ring forming process, the through-holes are formed to have a double structure. If so structured, the seal ring and the auxiliary ring are simultaneously formed not using any additional step.

Thus, in the embodiment, a vertical capacitor of large supplemental capacitance is formed around the chip peripheral edge and between the rings in a manner that the seal ring is double structured, and those resultant rings are connected to different potentials.

In the embodiment, in forming the multi-layered wiring, the seal ring and the auxiliary ring are formed as through-holes every layer and connected to the substrate potential. It is readily understood that those rings may be formed as through-holes passing through 2 or 3 layers.

The auxiliary ring may be formed in the lower layer region of the bonding pad. In this case, noise is reduced and the IR drop is lessened without increasing the occupying area. In the structure of the present invention, the seal ring and the auxiliary ring serve as power source annular wirings. Extension of the wiring is reduced. Accordingly, further reduction of the chip area is possible. The auxiliary ring is in contact with the n-well region 1202. Therefore, the potential of the n-well is stably fixed to a desired one.

In the embodiment, the auxiliary ring is in contact with the n-well region 1202. The invention will effectively operate in cases as shown in Figs. 14A and 14B: it is not opened in the substrate or it is opened in the element region.

While the seal ring is double structured in the embodiment, it may be triple structure or structures of a more number of layers. Further, those different potentials may be three or larger in number. It essential to make the potentials of the adjacent rings different. If required, two different potentials may alternately be arranged.

As wiring material, it is not limited by the above embodiments, and a refractive metal film such as tungsten, and another conductive thin film such as silicide file and Au film are applicable. Further as an insulating film, another insulating film can be used in accordance with permissivity etching characteristics and insulation characteristics.

As described above, in the semiconductor device and a method of manufacturing it according to this embodiment of the invention, a supplemental capacitor is formed using large capacitance between wirings, between through-holes, between an electrode layer and though-hole, or between the electrode layers because of downsizing of time process technique so that it can be formed at a desired position within the semiconductor device. For example, in the semiconductor device in which an analog circuit and a digital circuit are mixedly formed or the semiconductor device operating at a low voltage, the supplemental capacitor can be easily formed in the vicinity of the area where switching noise is generated, thereby effectively realizing the countermeasure for power source noise.

In the process technique with advanced downsizing, a capacitor having large capacitance can be formed with a smaller area than the capacitor between the wiring layers. In addition, the capacitor can be formed in the same process as the other device such as a transistor without adding any special step.

## Claims

**1.** A semiconductor device comprising:

a first conductive layer formed of a surface of a semiconductor substrate;
a second conductive layer which is formed close to the first conductive layer, wherein
a distance between the first conductive layer and the second conductive layer is determined in accordance with a permittivity of the insulating layer.

**2.** A semiconductor device according to claim 1: wherein the second conductive layer is made of a conductive film being filled in

a through hole being located close to said first conductive layer and passing through at least a part of the insulating film; and said first and second conductive layers are connected to first and second potentials, respectively, and a capacitor, which extends in the depth direction of said through hole, is formed by using said insulating inter-layer film interposed between said first conductive layer and said second conductive layer within said through hole.

**3.** A semiconductor device according to claim 2, wherein said through hole comprises a second through hole being electrically connected to a semiconductor region or a wiring region only at either of the opened ends thereof.

**4.** A semiconductor device according to claim 2, wherein said through-hole comprises a second through-hole opened to the surface of said insulating region formed on the surface of said substrate.

**5.** A semiconductor device according to any of claim 2, wherein said through-hole comprises a second through-hole opened to the surface of an element separation region formed on the surface of a semiconductor substrate as said substrate.

**6.** A semiconductor device according to claim 2, wherein said first conductive layer is formed within a first through-hole being separated by a predetermined distance from said through-hole, whereby a vertical capacitor, which extends in the depth direction of said through-hole, is formed by said first and second conductive layers and said insulating film interposed between said first and second conductive layers.

**7.** A semiconductor device according to claim 2, wherein said through-hole is rectangular in cross section, and the surface of said through-hole, which is confronted with said first conductive layer, is a wider surface.

**8.** A semiconductor device according to claim 2, wherein said through-hole comprises a third through-hole opened to the surface of said substrate so as to be electrically connected with the surface of said substrate, and a second through-hole opened to the surface of an insulating region formed on the surface of said substrate, said second and third through-holes being formed in the same manufacturing step, and the area of the opening of said second through-hole is larger than that of the opening of said third through-hole.

**9.** A semiconductor device according to claim 6, wherein said through-hole surrounds said first conductive layer while being separated a predetermined distance from the side wall of said first through-hole, and a vertical capacitor, which extends in the depth direction of said through-hole, is formed between the side wall of said first conductive layer and said second conductive layer, which are confronted with each other with said insulating film being interposed therebetween.

**10.** A semiconductor device according to claim 9, wherein said first conductive layer comprises an insulating protective layer formed on the side wall of said first conductive layer.

**11.** A semiconductor device according to claim 2, wherein said through-hole overlaps with at least a part of the upper surface of said first conductive layer, and a vertical capacitor, which extends in the depth direction of said through-hole, is formed between the side wall of said first conductive layer and said second conductive layer, which are confronted with each other with said insulating film being interposed therebetween.

**12.** A semiconductor device according to claim 11, wherein said first conductive layer comprises insulating protective films, which are formed on at least the side wall and the upper surface of said first conductive layer.

**13.** A semiconductor device according to claim 12, wherein said through-hole is opened to an areal range from the upper surface to both side walls of said first conductive layer.

**14.** A semiconductor device according to claim 10, wherein said insulating protective layer consists of a first insulating film and a second insulating film layered on said first insulating layer, said second insulating film having a permittivity smaller than that of said first insulating film and exhibiting etching resistance to the etching conditions of said insulating film.

**15.** A semiconductor device according to claim 2, wherein said first conductive layer surrounds the outside of said second conductive layer so as to be spaced a predetermined distance from said second conductive layer filled in said through-hole.

**16.** A semiconductor device according to claim 15, wherein said first conductive layer is formed in formed in a comb shape and said through-holes are formed at the positions sandwiched between the teeth of the comb.

**17.** A semiconductor device according to claim 2, wherein said first and second conductive layers are filled in said first and second through-holes, and the upper ends thereof are connected to said first end second conductive layers, and the spatial intervals in the arrays of said first and second conductive layers are smaller than those in the arrays of said first and second through-holes.

**18.** A semiconductor device according to claim 2, wherein said first and second conductive layers are filled in said first and second through-holes, and the upper ends thereof are connected to said first and second conductive layers, and the spatial intervals in the arrays of said first and second through-holes are smaller than those in the arrays of said first and second conductive layers.

**19.** A semiconductor device according to claim 2, wherein said first and second conductive layers are filled in said first and second through-holes, and the upper ends thereof are connected to said first and second conductive layers, and the spatial intervals in the arrays of said first and second through-holes are substantially equal to those in the arrays of said first and second conductive layers.

**20.** A semiconductor device according to claim 2, wherein said first conductive layer is a gate electrode wiring, and said second through-hole is a source or drain contact hole, and said second conductive layer is a source or drain wiring.

**21.** A semiconductor device according to claim 2, wherein said first conductive layer is a gate electrode wiring, and said second through-hole is formed on both sides of said gate electrode wiring on an element isolation region, while being spaced a predetermined distance therefrom.

**22.** A semiconductor device according to claim 2, wherein said first conductive layer is a gate electrode wiring, and second through-hole is formed along said gate electrode wiring so as to cover said gate electrode wiring of which the surface is covered with an insulating protective film on the element separation region, wherein a vertical capacitor is formed by said gate electrode wiring, said insulating protective film covering said gate electrode wiring, and said second conductive layer within said second through-hole.

**23.** A semiconductor device according to claim 19, wherein said insulating protective layer is a multi-layer film.

**24.** A semiconductor device according to claim 2, wherein said second through-hole and said second conductive layer filled therein form a seal ring which is formed surrounding the peripheral edge of the surface of the semiconductor chip, and said first conductive layer is an auxiliary ring formed in said first through-hole in a state that it is spaced a predetermined distance from said seal ring while being arranged parallel to said seal ring, and said seal ring and said auxiliary ring form a vertical capacitor.

**25.** A semiconductor device according to claim 24, wherein said auxiliary ring is formed so as to electrically contact with said substrate.

**26.** A semiconductor device according to claim 24, wherein said auxiliary ring is connected with anyone of power source line and signal line.

**27.** A method of manufacturing a semiconductor device comprising the steps of:

forming a desired element region in a semiconductor substrate;
forming a wiring layer on the surface of said semiconductor substrate; wherein
said wiring layer forming step comprises
a step of forming a first conductive layer,
a step of forming an insulating inter-layer film,
a step of forming a through-hole by selectively removing said insulating film, and
a step of forming a second conductive layer within said through-hole,

said through-hole forming step comprises a step for simultaneously forming a through-hole for circuit connection and a through-hole for forming a supplemental capacitor in which said first and second conductive layers within said through-hole are located close to each other,
wherein said first and second conductive layers are connected in part to first and second different potentials, thereby forming a capacitor.

**28.** A method of manufacturing a semiconductor device comprising the steps of:

forming a desired element region in a semiconductor substrate;
forming a wiring layer on the surface of said semiconductor substrate;
said wiring layer forming step comprises
a step of forming a first conductive layer,
a step of forming an insulating inter-layer film,
a step of forming a through-hole by selectively removing said insulating inter-layer film, and
a step of forming a second conductive layer within said through-hole,
said through-hole forming step comprises a step for simultaneously forming a through-hole for circuit connection and a through-hole for forming a supplemental capacitor in which at least said second conductive layers within said through-hole are located close to each other,
wherein said second conductive layers within said supplemental capacitor are connected to first and second different potentials, thereby forming a supplemental capacitor.

**29.** A method of manufacturing a semiconductor device according to claim 23, further comprising the steps of:

a step of forming a gate electrode film and a gate electrode layer on the surface of a semiconductor substrate including an element separation region;
a step of forming a source-drain region;
a step of forming an insulating inter-layer film;
a step of forming a through-hole so that said through-hole is opened to said source-drain region by selectively etching said insulating inter-layer film in the vicinity of said electrode layer; and
a step of forming, by forming a conductive layer, a wiring so that said wiring comes in contact with said source and drain regions through said through hole,
said through-hole forming step comprises a step for simultaneously forming said through-hole and another through-hole for a supplemental capacitor at a position located near said gate electrode wiring running on said element separation region,
wherein said wiring and electrode layers are connected to first and second different potentials, respectively, whereby a supplemental capacitor is formed.

**30.** A method of manufacturing a semiconductor device according to claim 29, wherein said electrode layer forming step comprises a step of covering said gate electrode with an insulating protective film after said gate electrode forming step.

**31.** A method of manufacturing a semiconductor device comprising the steps of:

forming an insulating inter-layer film on the surface of a substrate including a desired element region;
forming a through-hole by selectively removing a contact hole for electrical connection and said insulating inter-layer film; and
forming a second conductive layer within said through-hole,
said through-hole forming step including a step of forming a plurality of second through-holes while being spaced from one another in order to simultaneously forming a contact region for making an electrical contact and a vertical capacitor,
whereby the adjacent regions of said second conductive layers are respectively connected to first and second potentials, thereby forming a capacitor.

FIG. 1 (a)

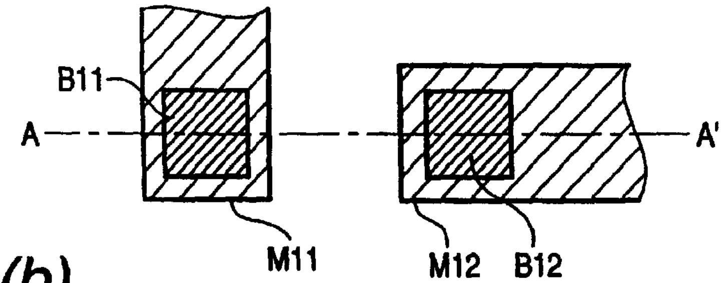


FIG. 1 (b)

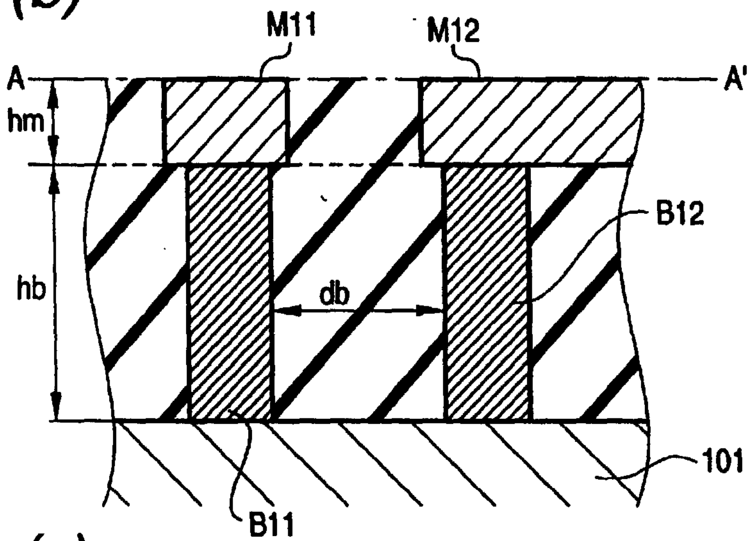


FIG. 1 (c)

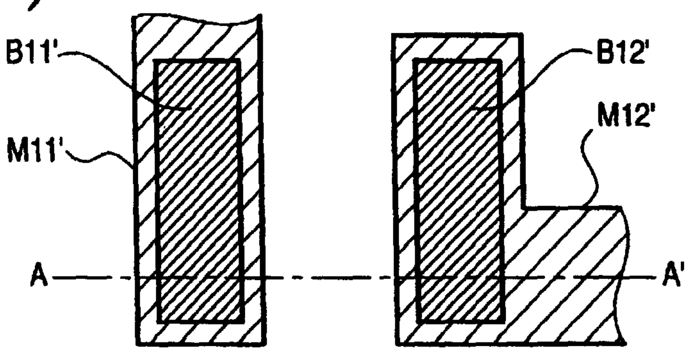

FIG. 2 (a)

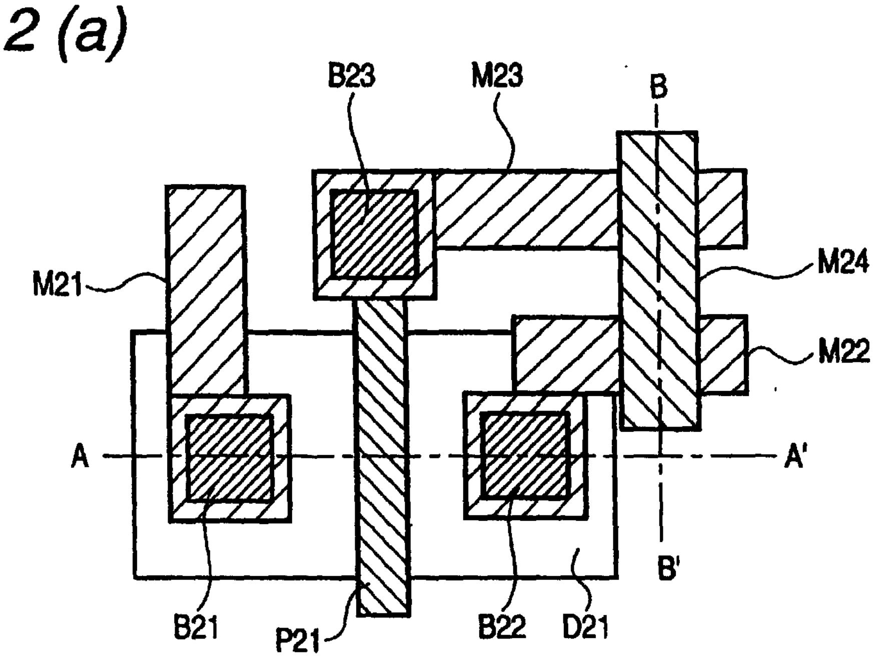


FIG. 2 (b)

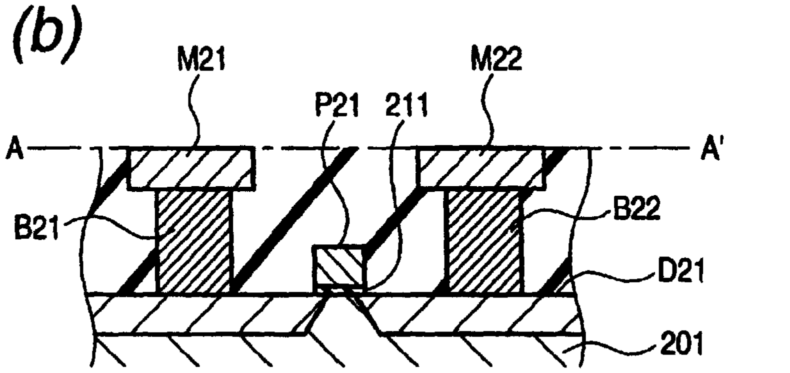


FIG. 2 (c)

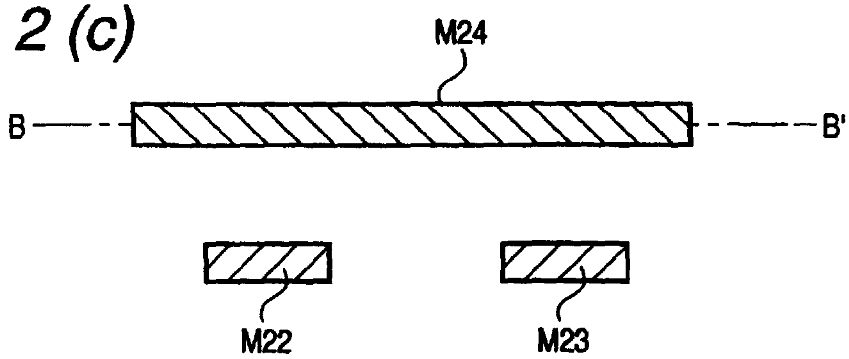

FIG. 3 (a)

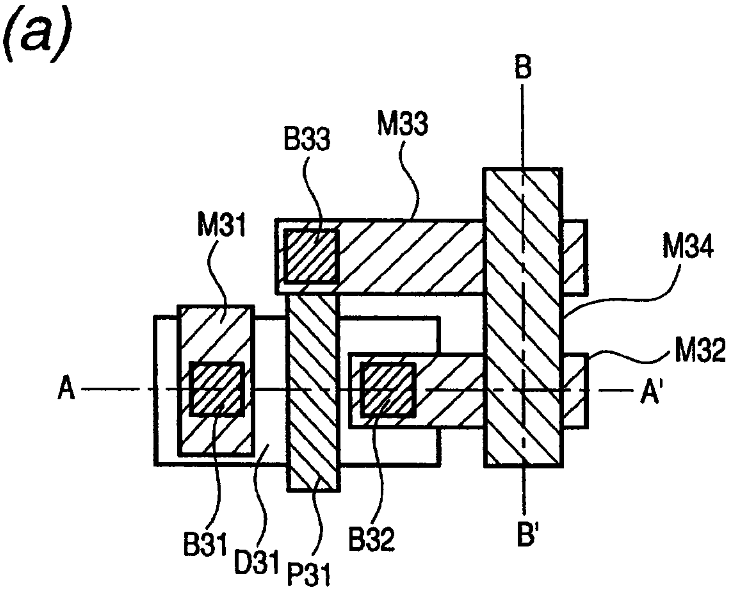


FIG. 3 (b)

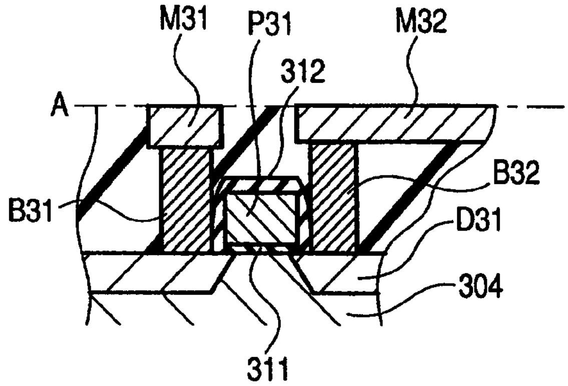


FIG. 3 (c)

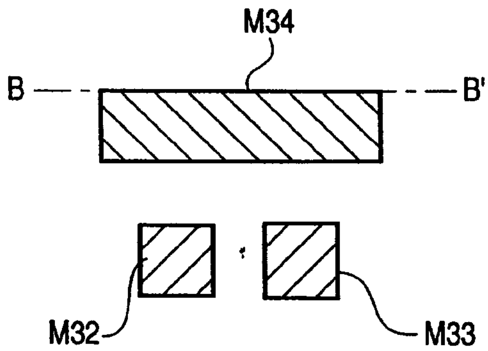

FIG. 4 (a)

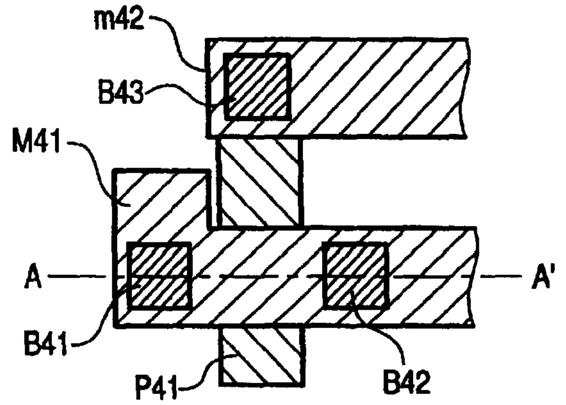


FIG. 4 (b)

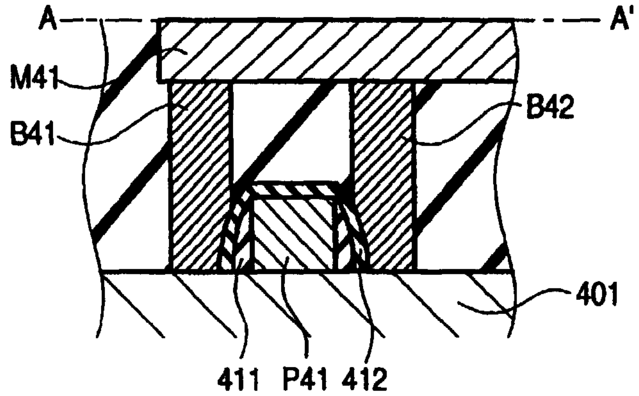


FIG. 4 (c)

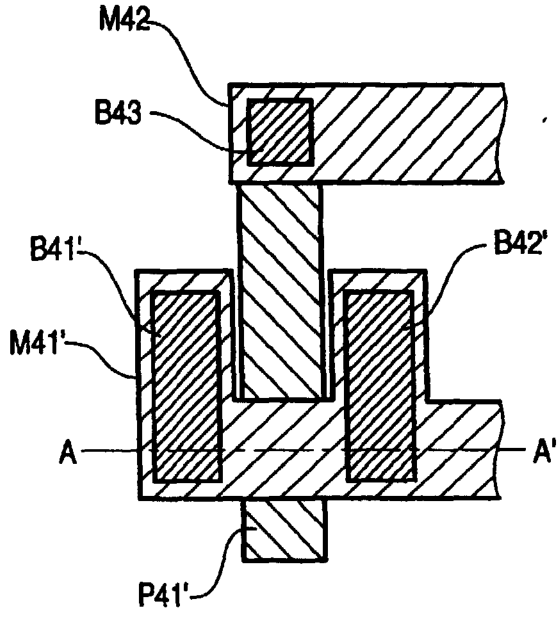

FIG. 5 (a)

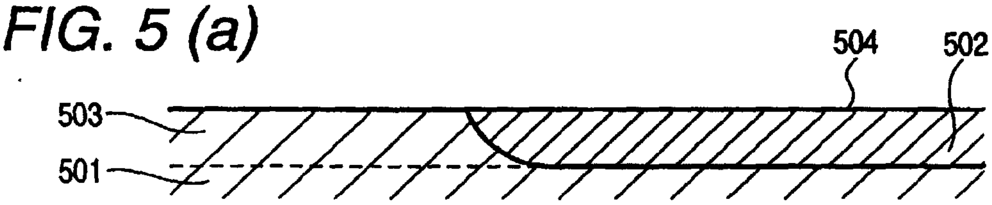


FIG. 5 (b)

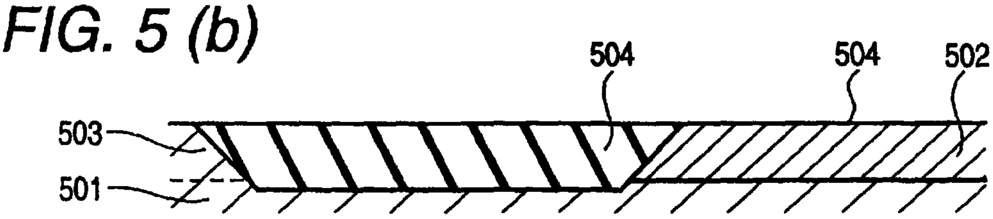


FIG. 5 (c)

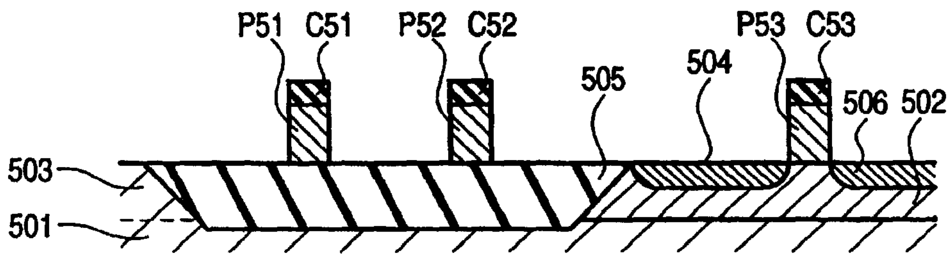


FIG. 5 (d)

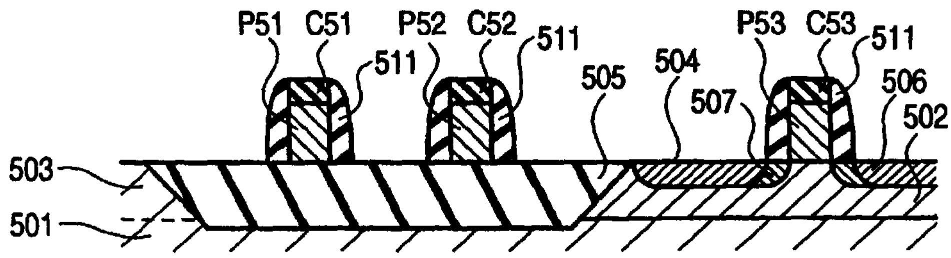


FIG. 5 (e)

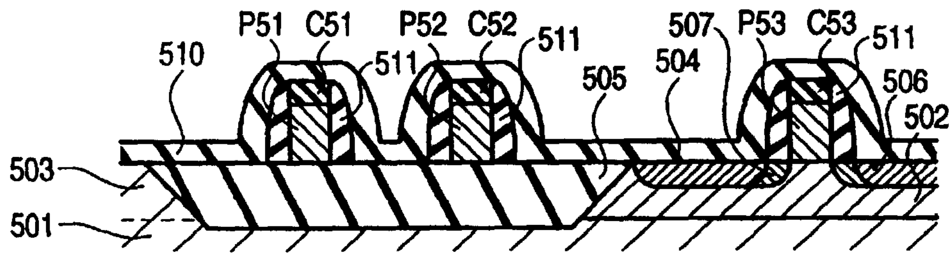

FIG. 6 (a)

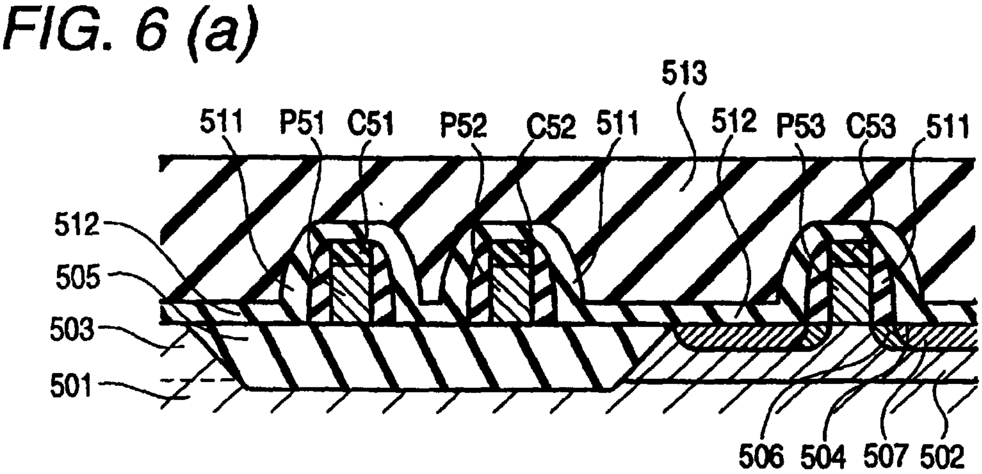


FIG. 6 (b)

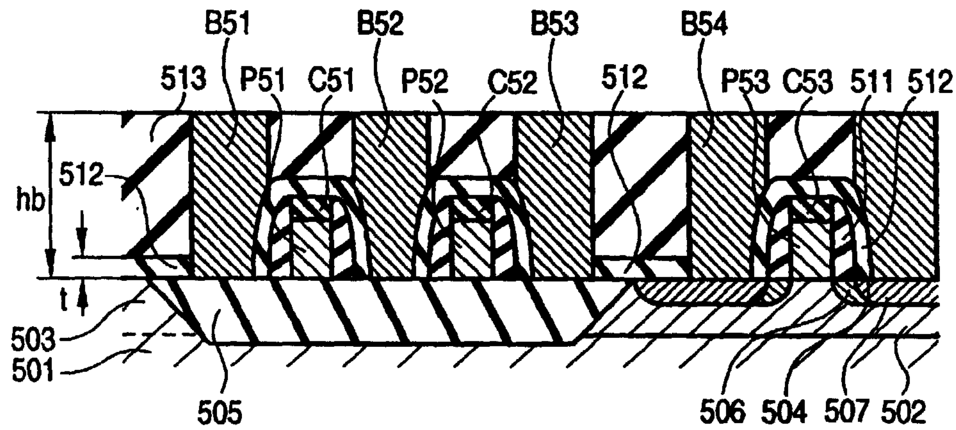


FIG. 6 (c)

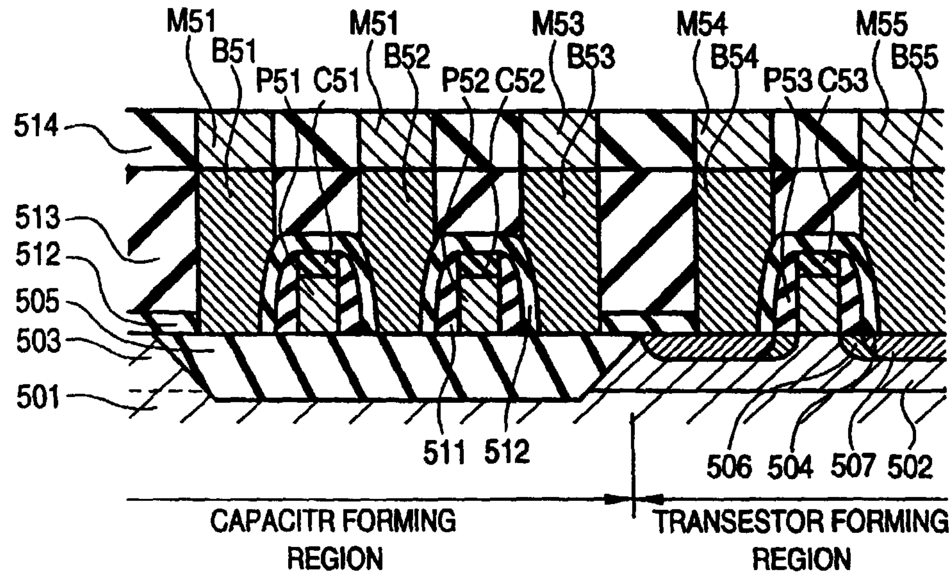

FIG. 7 (a)

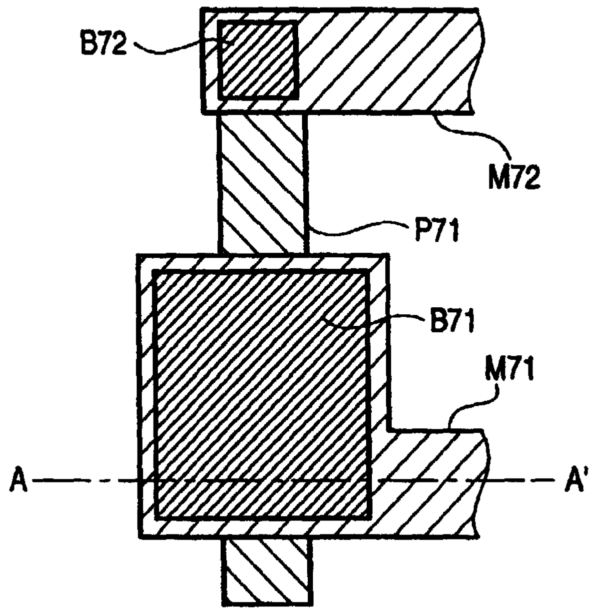


FIG. 7 (b)

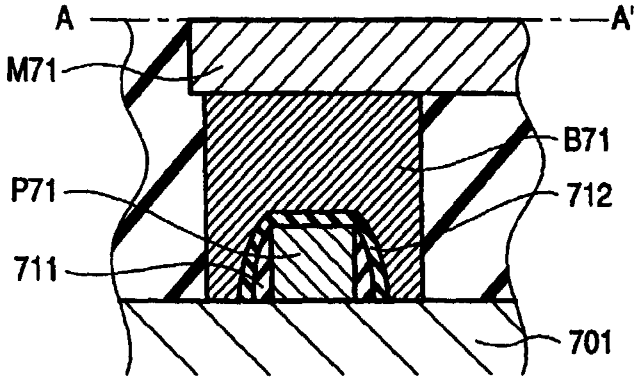

FIG. 8 (a)

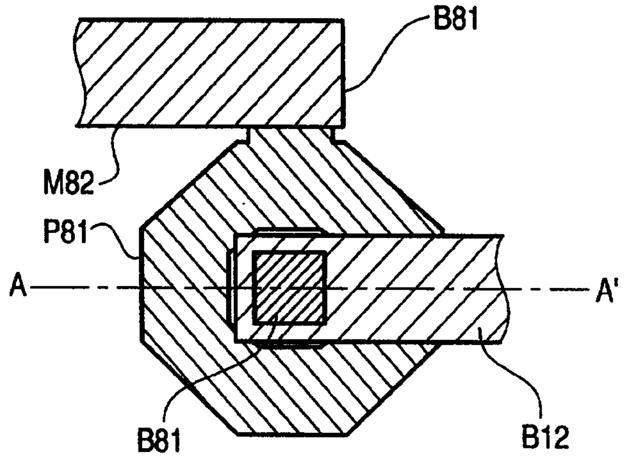


FIG. 8 (b)

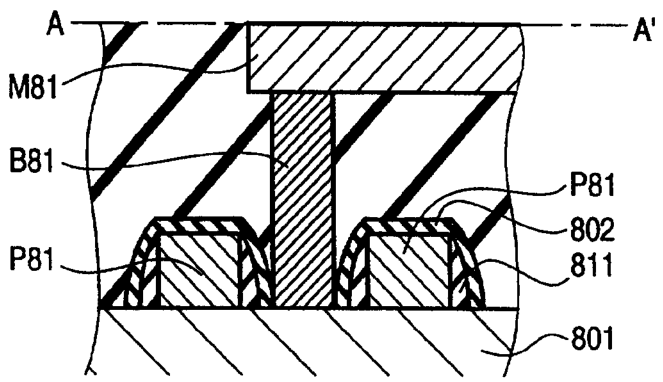

FIG. 9 (a)

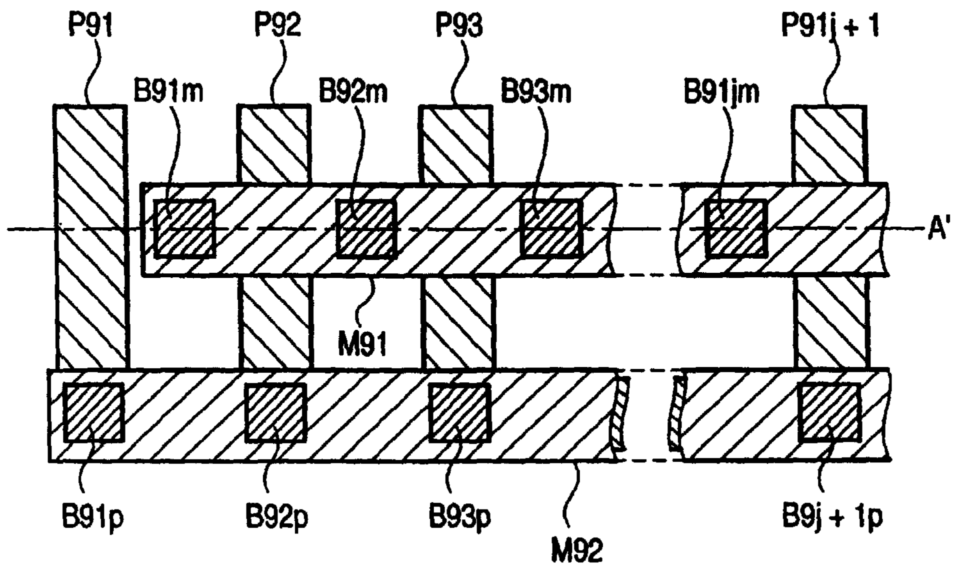
P91
P92
P93
P91j + 1
B91m
B92m
B93m
B91jm
A'
M91
B91p
B92p
B93p
M92
B9j + 1p

FIG. 9 (b)

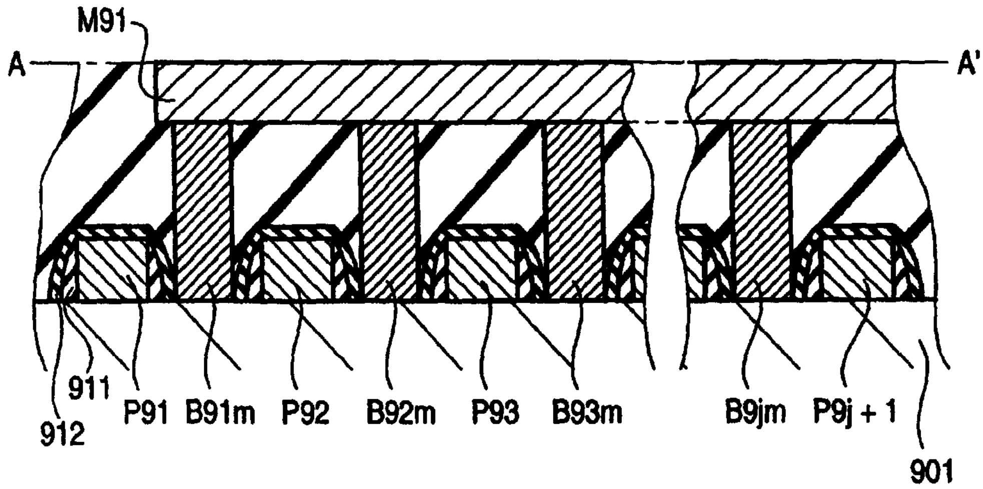
M91
A
A'
911
912
P91
B91m
P92
B92m
P93
B93m
B9jm
P9j + 1
901

FIG. 10 (a)

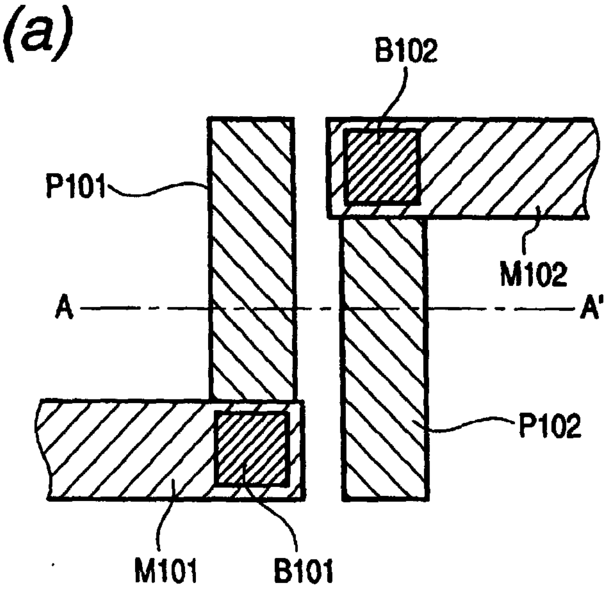


FIG. 10 (b)

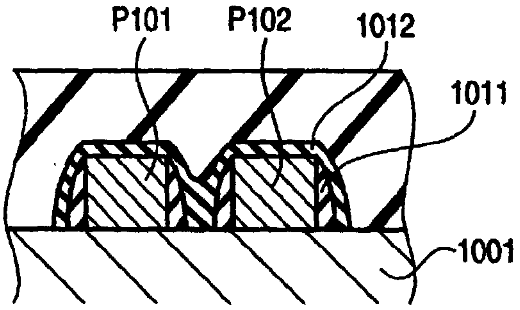


FIG. 11

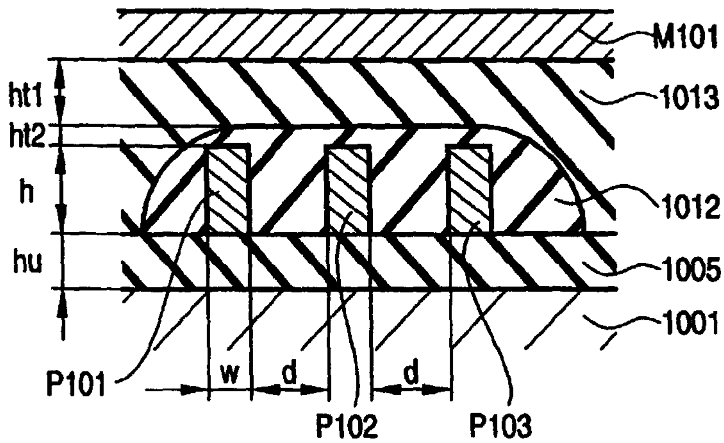

FIG. 12

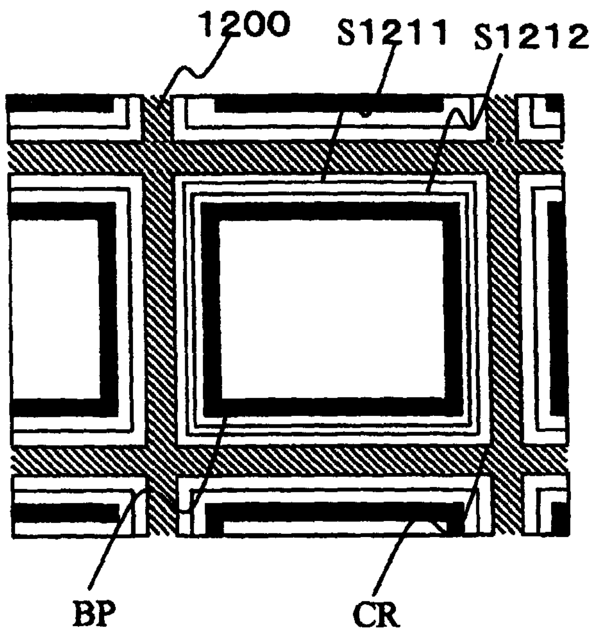

FIG. 13 (a)

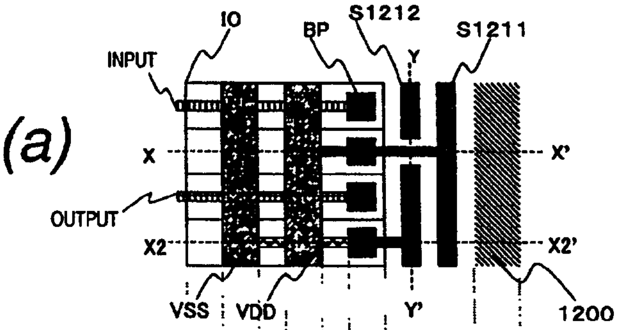


FIG. 13 (b)

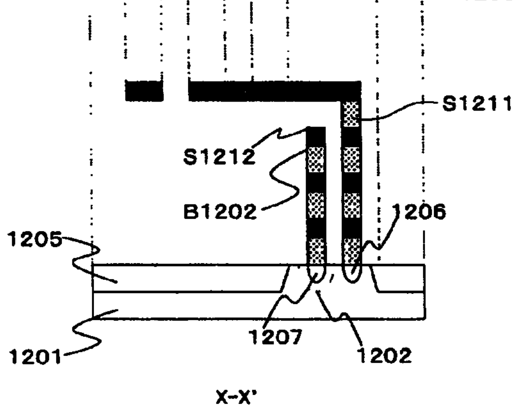


FIG. 13 (c)

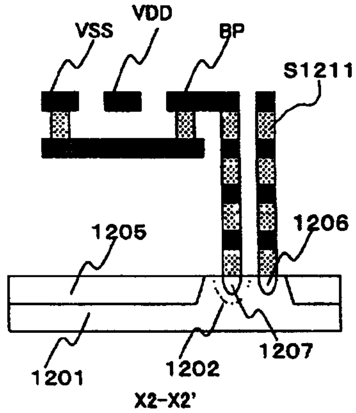


FIG. 13 (d)

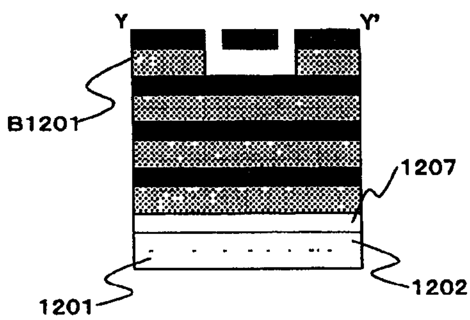

FIG. 14 (a)

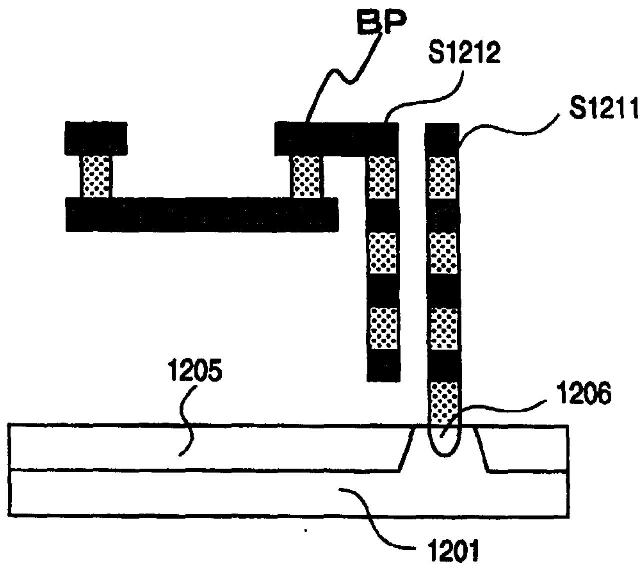


FIG. 14 (b)

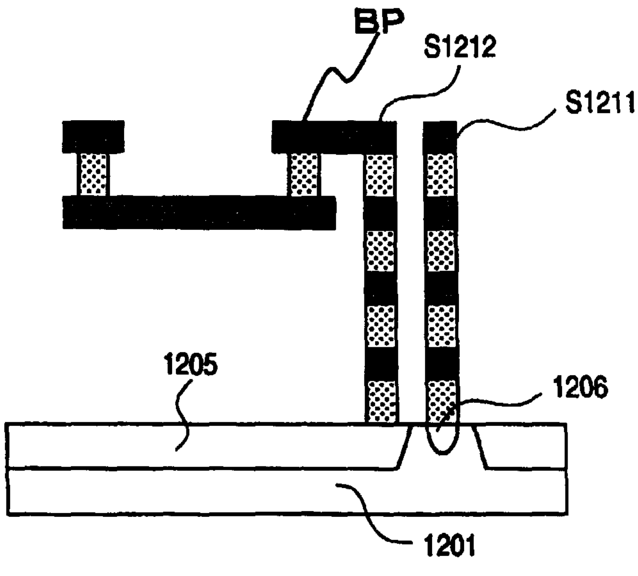

FIG. 15 (a)

FIG. 15 (b)

FIG. 15 (c)